(19) **Europäisches Patentamt / European Patent Office / Office européen des brevets**

(11) **EP 4 033 257 A1**

(12) # EUROPEAN PATENT APPLICATION
published in accordance with Art. 153(4) EPC

(43) Date of publication:
**27.07.2022 Bulletin 2022/30**

(21) Application number: **19954372.9**

(22) Date of filing: **26.11.2019**

(51) International Patent Classification (IPC):
***G01R 23/12*** *(2006.01)*

(52) Cooperative Patent Classification (CPC):
**G01R 23/12**

(86) International application number:
**PCT/JP2019/046159**

(87) International publication number:
**WO 2021/106072 (03.06.2021 Gazette 2021/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **MITSUBISHI ELECTRIC
CORPORATION
Chiyoda-ku
Tokyo 100-8310 (JP)**

(72) Inventors:
• **WADA, Osamu
Tokyo 100-8310 (JP)**
• **NAKAMIZO, Hideyuki
Tokyo 100-8310 (JP)**

(74) Representative: **Mewburn Ellis LLP
Aurora Building
Counterslip
Bristol BS1 6BX (GB)**

(54) **FREQUENCY DETECTION CIRCUIT AND RECEPTION DEVICE**

(57) A frequency detection circuit (3) includes a signal source (11) that outputs a first clock signal and a second clock signal that has the same frequency as the first clock signal and a different phase from the first clock signal, a S/H circuit (12) that undersamples a frequency-detection target signal using the first clock signal output from the signal source (11) and outputs a first sampling signal indicating a result of undersampling, and undersamples the frequency-detection target signal using the second clock signal output from the signal source (11) and outputs a second sampling signal indicating a result of undersampling, and a frequency calculation circuit (14) that calculates a phase difference between the first sampling signal output from the S/H circuit (12) and the second sampling signal output from the S/H circuit (12) and calculates the frequency of the frequency-detection target signal on the basis of the phase difference.

FIG. 1

EP 4 033 257 A1

**Description**

TECHNICAL FIELD

The present invention relates to a frequency detection circuit and a reception device that calculate the frequency of a frequency-detection target signal.

BACKGROUND ART

As a frequency detection circuit that detects the frequency of an input signal, there is a frequency detection circuit in which a plurality of processing systems that detect the frequency are connected in parallel.

For example, Patent Literature 1 below discloses a sampling system that includes a plurality of processing systems and a signal processing circuit. Each of the plurality of processing systems includes a delay unit, a sampler, and an A/D converter. The signal processing circuit calculates the frequency of a signal input to the sampling system from the frequencies calculated by the plurality of processing systems.

In the sampling system, sampling frequencies of a plurality of samplers that are samplers each included in the plurality of processing systems are the same, whereas delay times of a plurality of delay units that are delay units each included in the plurality of processing systems are different from each other. Since the delay times of the plurality of delay units are different from each other, the frequency is calculated by the time interleaving process in the sampling system.

When the time interleaving process is performed in the sampling system, if the sampling frequency of the plurality of samplers is fc and the number of parallel of the plurality of processing systems is N, the overall sampling frequency of the sampling system is equivalent to $N \times fc$. When the frequency of the input signal is fin, if $fin < 2 \times N \times fc$, the sampling in the sampling system is oversampling in accordance with the sampling theorem. In a case where the sampling in the sampling system is oversampling, the accuracy of frequency calculation in the sampling system is higher than the accuracy of frequency calculation in a sampling system including only one processing system.

CITATION LIST

PATENT LITERATURES

Patent Literature 1: JP 2017-216604 A

SUMMARY OF INVENTION

TECHNICAL PROBLEM

In order to implement oversampling in a sampling system including a plurality of processing systems, it is necessary to increase the number N of parallel of the plurality of processing systems as the frequency fin of an input signal becomes higher. Therefore, there is a problem that the circuit scale of the sampling system increases as the frequency fin of the input signal becomes higher.

The present invention has been made to solve the above problems, and an object of the present invention is to obtain a frequency detection circuit and a reception device capable of calculating the frequency of a frequency-detection target signal by the same circuit as when the frequency is low even if the frequency of the frequency-detection target signal is high.

SOLUTION TO PROBLEM

A frequency detection circuit according to the present invention includes a signal source to output a first clock signal and a second clock signal that has a same frequency as the first clock signal and a different phase from the first clock signal, a sample and hold circuit to undersample a frequency-detection target signal using a first clock signal output from the signal source and output a first sampling signal indicating a result of undersampling, and undersample the frequency-detection target signal using a second clock signal output from the signal source and output a second sampling signal indicating a result of undersampling, and a frequency calculation circuit to calculate a phase difference between a first sampling signal output from the sample and hold circuit and a second sampling signal output from the sample and hold circuit and calculate a frequency of the frequency-detection target signal on a basis of the phase difference.

ADVANTAGEOUS EFFECTS OF INVENTION

According to the present invention, even if the frequency of the frequency-detection target signal is high, the frequency of the frequency-detection target signal can be calculated by the same circuit as when the frequency is low.

BRIEF DESCRIPTION OF DRAWINGS

FIG. 1 is a configuration diagram illustrating a reception device including a frequency detection circuit 3 according to a first embodiment.
FIG. 2 is a configuration diagram illustrating a frequency calculation circuit 14 of the frequency detection circuit 3 according to the first embodiment.
FIG. 3 is an explanatory diagram illustrating a frequency component included in an input signal of an S/H circuit 12, a frequency component included in an output signal of the S/H circuit 12, and a frequency component included in an output signal of a filter 13.
FIG. 4 is an explanatory diagram illustrating the output signal of the filter 13 and an operation of a phase calculation circuit 23.
FIG. 5 is a configuration diagram illustrating another frequency calculation circuit 14 of the frequency detection circuit 3 according to the first embodiment.
FIG. 6 is a configuration diagram illustrating yet another frequency calculation circuit 14 of the frequency detection circuit 3 according to the first embodiment.
FIG. 7 is a configuration diagram illustrating a reception device according to a second embodiment.
FIG. 8 is a flowchart illustrating an operation of an arithmetic circuit 52 in the reception device according to the second embodiment.

DESCRIPTION OF EMBODIMENTS

Hereinafter, in order to describe the present invention in more detail, embodiments for carrying out the present invention will be described with reference to the accompanying drawings.

First Embodiment

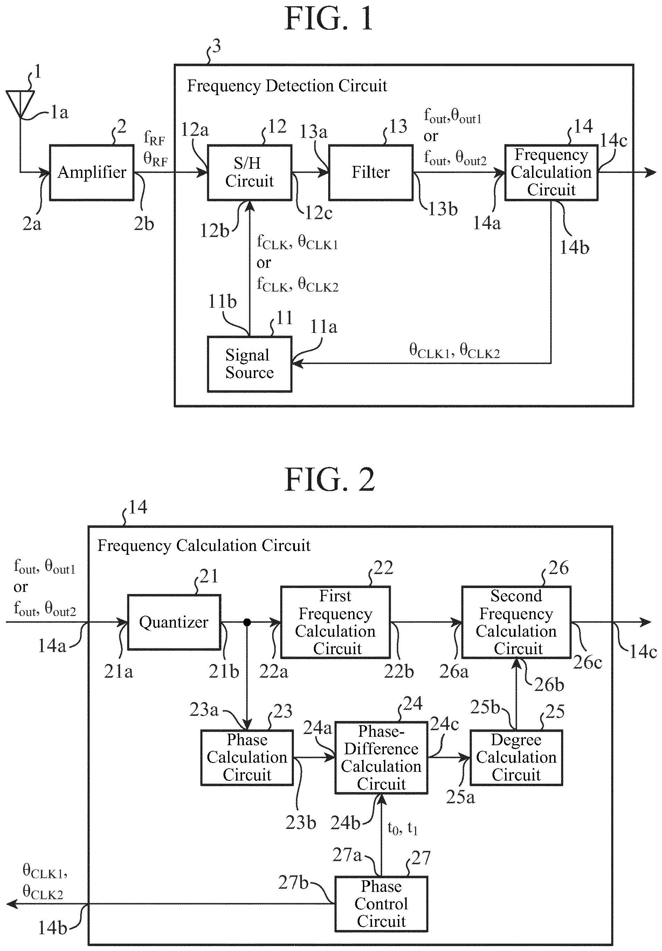

FIG. 1 is a configuration diagram illustrating a reception device including a frequency detection circuit 3 according to a first embodiment.
The reception device illustrated in FIG. 1 includes an antenna 1, an amplifier 2, and the frequency detection circuit 3.
The antenna 1 is implemented by, for example, a dipole antenna, a patch antenna, or an array antenna.
An output terminal 1a of the antenna 1 is connected to an input terminal 2a of the amplifier 2.
The antenna 1 receives a frequency-detection target signal propagating in space, and outputs the received signal to the amplifier 2.
The frequency of the signal received by the antenna 1 is $f_{RF}$, and the phase of the signal received by the antenna 1 is $\theta_{RF}$. Consequently, the frequency of the frequency-detection target signal in the frequency detection circuit 3 is $f_{RF}$.
The amplifier 2 is implemented by, for example, a discrete semiconductor transistor.
The input terminal 2a of the amplifier 2 is connected to the output terminal 1a of the antenna 1, and an output terminal 2b of the amplifier 2 is connected to an input terminal 12a of the sample and hold circuit (hereinafter, referred to as "S/H circuit") 12 of the frequency detection circuit 3, which will be described later.
The amplifier 2 amplifies the power of the signal received by antenna 1, and outputs the power-amplified signal to the S/H circuit 12.
Note that the amplifier 2 is desirably an amplifier that adds less noise to the signal received by the antenna 1. It is assumed that the amplifier 2 amplifies the power to such an extent that the influence of the noise figure on the frequency detection circuit 3 can be ignored.
The frequency detection circuit 3 includes a signal source 11, the S/H circuit 12, a filter 13, and the frequency calculation circuit 14.
The frequency detection circuit 3 detects the frequency $f_{RF}$ of the signal subjected to the power amplification by the amplifier 2 as the frequency $f_{RF}$ of the frequency-detection target signal, and outputs a signal indicating the frequency $f_{RF}$ to the outside of the device.
The signal source 11 is implemented by, for example, a digital-to-analog converter (DAC), a direct digital synthesizer (DDS), or a phase locked loop (PLL) circuit.

A control terminal 11a of the signal source 11 is connected to a first output terminal 14b of the frequency calculation circuit 14, and an output terminal 11b of the signal source 11 is connected to a clock terminal 12b of the S/H circuit 12.

When an output signal of the frequency calculation circuit 14 is a signal indicating a phase $\theta_{CLK1}$ of a first clock signal, the signal source 11 generates the first clock signal with the frequency $f_{CLK}$ and the phase $\theta_{CLK1}$.

When the output signal of the frequency calculation circuit 14 is a signal indicating a phase $\theta_{CLK2}$ of a second clock signal, the signal source 11 generates the second clock signal with the frequency $f_{CLK}$ and the phase $\theta_{CLK2}$.

The frequency $f_{CLK}$ of the first clock signal and the frequency $f_{CLK}$ of the second clock signal are the same, and the phase $\theta_{CLK1}$ of the first clock signal and the phase $\theta_{CLK2}$ of the second clock signal are different.

In the frequency detection circuit 3 illustrated in FIG. 1, the signal source 11 generates the first clock signal on the basis of the phase $\theta_{CLK1}$ indicated by the signal output from the frequency calculation circuit 14, and generates the second clock signal on the basis of the phase $\theta_{CLK2}$ indicated by the signal output from the frequency calculation circuit 14. However, this is merely an example, and the signal source 11 may generate each of the first clock signal and the second clock signal on the basis of a control signal or the like provided from the outside of the device.

The S/H circuit 12 is implemented by, for example, a circuit that includes a changeover switch that switches between open and short-circuit of a line through which a signal subjected to the power amplification by the amplifier 2 propagates and a capacitor that stores a charge when the line is opened by the changeover switch.

The input terminal 12a of the S/H circuit 12 is connected to the output terminal 2b of the amplifier 2, the clock terminal 12b of the S/H circuit 12 is connected to the output terminal 11b of the signal source 11, and an output terminal 12c of the S/H circuit 12 is connected to an input terminal 13a of the filter 13.

The S/H circuit 12 undersamples the signal subjected to the power amplification by the amplifier 2 using the first clock signal output from the signal source 11, and outputs a first sampling signal indicating a result of undersampling to the filter 13.

The S/H circuit 12 undersamples the signal subjected to the power amplification by the amplifier 2 using the second clock signal output from the signal source 11, and outputs a second sampling signal indicating a result of undersampling to the filter 13.

The filter 13 is implemented by, for example, a chip inductor and a chip capacitor.

The filter 13 has a predetermined pass band. The filter 13 is, for example, a low pass filter (LPF), a high pass filter (HPF), or a band pass filter (BPF).

The input terminal 13a of the filter 13 is connected to the output terminal 12c of the S/H circuit 12, and an output terminal 13b of the filter 13 is connected to an input terminal 14a of the frequency calculation circuit 14.

When receiving the first sampling signal from the S/H circuit 12, the filter 13 passes frequency components within the pass band and suppresses frequency components outside the pass band in the first sampling signal.

When receiving the second sampling signal from the S/H circuit 12, the filter 13 passes frequency components within the pass band and suppresses frequency components outside the pass band in the second sampling signal.

The filter 13 may mount a microstrip line, a coaxial resonator, or the like depending on a pass band in which the filter 13 passes frequency components or a necessary amount of suppression of frequency components by the filter 13.

The input terminal 14a of the frequency calculation circuit 14 is connected to the output terminal 13b of the filter 13, the first output terminal 14b of the frequency calculation circuit 14 is connected to the control terminal 11a of the signal source 11, and a second output terminal 14c of the frequency calculation circuit 14 is connected to an external circuit (not illustrated).

The frequency calculation circuit 14 calculates a phase difference $\theta_{out2}-\theta_{out1}$ or a phase difference $\theta_{out1}-\theta_{out2}$ between the first sampling signal output from the S/H circuit 12 and having passed through the filter 13 and the second sampling signal output from the S/H circuit 12 and having passed through the filter 13.

On the basis of the phase difference $\theta_{out2}-\theta_{out1}$ or the phase difference $\theta_{out1}-\theta_{out2}$, the frequency calculation circuit 14 calculates the frequency $f_{RF}$ of the signal subjected to the power amplification by the amplifier 2 as the frequency $f_{RF}$ of the frequency-detection target signal.

The frequency calculation circuit 14 outputs a signal indicating the frequency $f_{RF}$ of the frequency-detection target signal to the outside of the device.

In addition, the frequency calculation circuit 14 outputs a signal indicating the phase $\theta_{CLK1}$ of the first clock signal or a signal indicating the phase $\theta_{CLK2}$ of the second clock signal to the signal source 11.

FIG. 2 is a configuration diagram illustrating the frequency calculation circuit 14 of the frequency detection circuit 3 according to the first embodiment.

The frequency calculation circuit 14 includes a quantizer 21, a first frequency calculation circuit 22, a phase calculation circuit 23, a phase-difference calculation circuit 24, a degree calculation circuit 25, a second frequency calculation circuit 26, and a phase control circuit 27.

The quantizer 21 is implemented by, for example, an analog to digital converter (ADC).

An input terminal 21a of the quantizer 21 is connected to the input terminal 14a of the frequency calculation circuit 14, and an output terminal 21b of the quantizer 21 is connected to each of an input terminal 22a of the first frequency calculation circuit 22 and an input terminal 23a of the phase calculation circuit 23.

The quantizer 21 quantizes a first sampling signal output from the S/H circuit 12 and having passed through the filter 13, and outputs the quantized first sampling signal to each of the first frequency calculation circuit 22 and the phase calculation circuit 23.

The quantizer 21 quantizes a second sampling signal output from the S/H circuit 12 and having passed through the filter 13, and outputs the quantized second sampling signal to each of the first frequency calculation circuit 22 and the phase calculation circuit 23.

The first frequency calculation circuit 22 is implemented by, for example, a field programmable gate array (FPGA).

The input terminal 22a of the first frequency calculation circuit 22 is connected to the output terminal 21b of the quantizer 21, and an output terminal 22b of the first frequency calculation circuit 22 is connected to a first input terminal 26a of the second frequency calculation circuit 26.

The first frequency calculation circuit 22 calculates the frequency $f_{out}$ of the first sampling signal by performing, for example, fast Fourier transform (FFT) on the quantized first sampling signal output from the quantizer 21, and outputs a signal indicating the frequency $f_{out}$ to the second frequency calculation circuit 26.

The first frequency calculation circuit 22 calculates the frequency $f_{out}$ of the second sampling signal by performing, for example, FFT on the quantized second sampling signal output from the quantizer 21, and outputs a signal indicating the frequency $f_{out}$ to the second frequency calculation circuit 26.

Since the frequency $f_{out}$ of the first sampling signal and the frequency $f_{out}$ of the second sampling signal are the same, the first frequency calculation circuit 22 can calculate either the frequency $f_{out}$ of the first sampling signal or the frequency $f_{out}$ of the second sampling signal.

The phase calculation circuit 23 is implemented by, for example, an FPGA.

The input terminal 23a of the phase calculation circuit 23 is connected to the output terminal 21b of the quantizer 21, and an output terminal 23b of the phase calculation circuit 23 is connected to a first input terminal 24a of the phase-difference calculation circuit 24.

The phase calculation circuit 23 calculates the phase $\theta_{out1}$ of the first sampling signal by performing, for example, FFT on the quantized first sampling signal output from the quantizer 21, and outputs a signal indicating the phase $\theta_{out1}$ to the phase-difference calculation circuit 24.

The phase calculation circuit 23 calculates the phase $\theta_{out2}$ of the second sampling signal by performing, for example, FFT on the quantized second sampling signal output from the quantizer 21, and outputs a signal indicating the phase $\theta_{out2}$ to the phase-difference calculation circuit 24.

The phase-difference calculation circuit 24 is implemented by, for example, a memory that stores the phases $\theta_{out1}$ and $\theta_{out2}$ indicated by the signal output from the phase calculation circuit 23, and an FPGA.

The first input terminal 24a of the phase-difference calculation circuit 24 is connected to the output terminal 23b of the phase calculation circuit 23, a second input terminal 24b of the phase-difference calculation circuit 24 is connected to a first output terminal 27a of the phase control circuit 27, and an output terminal 24c of the phase-difference calculation circuit 24 is connected to an input terminal 25a of the degree calculation circuit 25.

When receiving a signal indicating a time to from the phase control circuit 27, the phase-difference calculation circuit 24 stores the phase $\theta_{out1}$ of the first sampling signal indicated by the signal output from the phase calculation circuit 23 in the memory.

When receiving a signal indicating a time $t_1$ from the phase control circuit 27, the phase-difference calculation circuit 24 stores the phase $\theta_{out2}$ of the second sampling signal indicated by the signal output from the phase calculation circuit 23 in the memory.

The phase-difference calculation circuit 24 calculates the phase difference $\theta_{out2}-\theta_{out1}$ or the phase difference $\theta_{out1}-\theta_{out2}$ between the first sampling signal and the second sampling signal from the phase $\theta_{out1}$ of the first sampling signal and the phase $\theta_{out2}$ of the second sampling signal.

The phase-difference calculation circuit 24 outputs a signal indicating the phase difference $\theta_{out2}-\theta_{out1}$ or a signal indicating the phase difference $\theta_{out1}-\theta_{out2}$ to the degree calculation circuit 25.

The degree calculation circuit 25 is implemented by, for example, a memory that stores a phase difference $\theta_{CLK2}-\theta_{CLK1}$ between a phase $\theta_{CLK1}$ of the first clock signal and a phase $\theta_{CLK2}$ of the second clock signal, and an FPGA.

The input terminal 25a of the degree calculation circuit 25 is connected to the output terminal 24c of the phase-difference calculation circuit 24, and an output terminal 25b of the degree calculation circuit 25 is connected to a second input terminal 26b of the second frequency calculation circuit 26.

The degree calculation circuit 25 calculates a degree n of undersampling by using the phase difference $\theta_{out2}-\theta_{out1}$ indicated by the signal output from the phase-difference calculation circuit 24 or the phase difference $\theta_{out1}-\theta_{out2}$ indicated by the signal output from the phase-difference calculation circuit 24 and the phase difference $\theta_{CLK2}-\theta_{CLK1}$

stored in the memory.

The degree calculation circuit 25 outputs a signal indicating the degree n to the second frequency calculation circuit 26.

The second frequency calculation circuit 26 is implemented by, for example, a memory that stores the frequency $f_{CLK}$ of the first clock signal or the frequency $f_{CLK}$ of the second clock signal, and an FPGA.

The first input terminal 26a of the second frequency calculation circuit 26 is connected to the output terminal 22b of the first frequency calculation circuit 22, the second input terminal 26b of the second frequency calculation circuit 26 is connected to the output terminal 25b of the degree calculation circuit 25, and an output terminal 26c of the second frequency calculation circuit 26 is connected to the second output terminal 14c of the frequency calculation circuit 14.

The second frequency calculation circuit 26 calculates, as the frequency $f_{RF}$ of the frequency-detection target signal, the frequency $f_{RF}$ of the signal subjected to the power amplification by the amplifier 2 using the frequency $f_{out}$ indicated by the signal output from the first frequency calculation circuit 22, the frequency $f_{CLK}$ stored in the memory, and the degree n indicated by the signal output from the degree calculation circuit 25.

The second frequency calculation circuit 26 outputs a signal indicating the frequency $f_{RF}$ of the frequency-detection target signal to the outside of the device.

The phase control circuit 27 is implemented by, for example, a memory that stores the phase $\theta_{CLK1}$ of the first clock signal or the phase $\theta_{CLK2}$ of the second clock signal, and an FPGA.

The first output terminal 27a of the phase control circuit 27 is connected to the second input terminal 24b of the phase-difference calculation circuit 24, and a second output terminal 27b of the phase control circuit 27 is connected to the first output terminal 14b of the frequency calculation circuit 14.

When the current time is $t_0$, the phase control circuit 27 outputs a signal indicating the time to to the phase-difference calculation circuit 24.

When outputting the signal indicating the time to to the phase-difference calculation circuit 24, the phase control circuit 27 outputs a signal indicating the phase $\theta_{CLK1}$ of the first clock signal stored in the memory to the signal source 11.

When the current time is $t_1$, the phase control circuit 27 outputs a signal indicating the time $t_1$ to the phase-difference calculation circuit 24. The time $t_0$ is earlier than the time $t_1$.

When outputting the signal indicating the time $t_1$ to the phase-difference calculation circuit 24, the phase control circuit 27 outputs a signal indicating the phase $\theta_{CLK2}$ of the second clock signal stored in the memory to the signal source 11.

Next, an operation of the reception device illustrated in FIG. 1 will be described.

The antenna 1 receives a frequency-detection target signal propagating in space, and outputs the received signal to the amplifier 2.

The frequency of the signal received by the antenna 1 is $f_{RF}$, and the phase of the signal received by the antenna 1 is $\theta_{RF}$.

The amplifier 2 amplifies the power of the signal received by the antenna 1, and outputs the power-amplified signal to the S/H circuit 12.

When the current time is $t_0$, the phase control circuit 27 of the frequency calculation circuit 14 outputs a signal indicating the time to to the phase-difference calculation circuit 24, and outputs a signal indicating the phase $\theta_{CLK1}$ of the first clock signal to the signal source 11.

In a time period of time to $\leq t \leq t_1$, the signal source 11 generates the first clock signal with the frequency $f_{CLK}$ and the phase $\theta_{CLK1}$ on the basis of the phase $\theta_{CLK1}$ indicated by the signal output from the phase control circuit 27. The signal source 11 outputs the first clock signal to the S/H circuit 12.

When the current time is $t_1$, the phase control circuit 27 outputs a signal indicating the time $t_1$ to the phase-difference calculation circuit 24, and outputs a signal indicating the phase $\theta_{CLK2}$ of the second clock signal to the signal source 11.

In a time period of time $t_1 < t \leq t_2$, the signal source 11 generates the second clock signal with the frequency $f_{CLK}$ and the phase $\theta_{CLK2}$ on the basis of the phase $\theta_{CLK2}$ indicated by the signal output from the phase control circuit 27. The signal source 11 outputs the second clock signal to the S/H circuit 12.

When receiving the first clock signal from the signal source 11, the S/H circuit 12 undersamples the signal subjected to the power amplification by the amplifier 2 in synchronization with the first clock signal.

The S/H circuit 12 outputs a first sampling signal indicating a result of undersampling to the filter 13.

When receiving the second clock signal from the signal source 11, the S/H circuit 12 undersamples the signal subjected to the power amplification by the amplifier 2 in synchronization with the second clock signal.

The S/H circuit 12 outputs a second sampling signal indicating a result of undersampling to the filter 13.

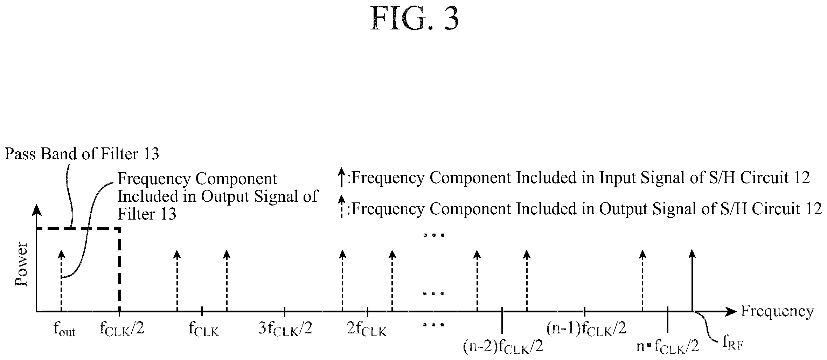

FIG. 3 is an explanatory diagram illustrating a frequency component included in an input signal of the S/H circuit 12, a frequency component included in an output signal of the S/H circuit 12, and a frequency component included in an output signal of the filter 13. In FIG. 3, the horizontal axis represents a frequency, and the vertical axis represents a power.

The input signal of the S/H circuit 12 is a signal subjected to the power amplification by the amplifier 2, and includes a component of the frequency $f_{RF}$ indicated by a solid arrow in the drawing.

The output signals of the S/H circuit 12 are the first sampling signal and the second sampling signal. In the spectrum of the output signal of the S/H circuit 12, a folded component indicated by a broken line arrow in the drawing is generated every integer multiple of a half (hereinafter, referred to as "Nyquist frequency") of the frequency $f_{CLK}$ of each of the first clock signal and the second clock signal.

Consequently, the output signal of the S/H circuit 12 has a plurality of frequency components, and assuming that each frequency related to each of the plurality of frequency components is $f_{S/H}$, the frequency $f_{S/H}$ is represented by the following expression (1).

$$f_{S/H} = |f_{RF} \pm \alpha \cdot f_{CLK}| \qquad (1)$$

In the expression (1), $\alpha$ is an integer.

When receiving the first sampling signal from the S/H circuit 12, the filter 13 passes frequency components within a pass band and suppresses frequency components outside the pass band in the first sampling signal.

When receiving the second sampling signal from the S/H circuit 12, the filter 13 passes frequency components within the pass band and suppresses frequency components outside the pass band in the second sampling signal.

In the example of FIG. 3, the pass band of the filter 13 is a pass band in which a frequency component with the lowest frequency $f_{S/H}$ among a plurality of frequency components included in the output signal of the S/H circuit 12 is passed. Assuming that the frequency of the frequency component with the lowest frequency $f_{S/H}$ is $f_{out}$, the frequency $f_{out}$ is represented by the following expression (2) or (3). That is, when a product $nf_{CLK}$ of the frequency $f_{CLK}$ of the first clock signal or the frequency $f_{CLK}$ of the second clock signal and the degree n of undersampling is less than or equal to the frequency $f_{RF}$ of the frequency-detection target signal, the frequency $f_{out}$ is represented by the expression (2). In addition, when the product $nf_{CLK}$ is larger than the frequency $f_{RF}$ of the frequency-detection target signal, the frequency $f_{out}$ is represented by the expression (3).

In the case where $f_{RF} \geqq n \cdot f_{CLK}$

$$f_{out} = f_{RF} - n \cdot f_{CLK} \qquad (2)$$

In the case where $f_{RF} < n \cdot f_{CLK}$

$$f_{out} = -f_{RF} + n \cdot f_{CLK} \qquad (3)$$

Assuming that the frequency of the output signal of the filter 13 is $f_{out}$ and the phase of the output signal of the filter 13 at the time $t_0 \leq t \leq t_1$ is $\theta_{out1}$, the phase $\theta_{out1}$ is expressed by the following expression (4) or (5). That is, when the product $nf_{CLK}$ is less than or equal to the frequency $f_{RF}$ of the frequency-detection target signal, the phase $\theta_{out1}$ is represented by the expression (4). In addition, when the product $nf_{CLK}$ is larger than the frequency $f_{RF}$ of the frequency-detection target signal, the phase $\theta_{out1}$ is represented by the expression (5).

In the case where $f_{RF} \geqq n \cdot f_{CLK}$,

$$\theta_{out1} = \theta_{RF} - n \cdot \theta_{CLK1} \qquad (4)$$

In the case where $f_{RF} < n \cdot f_{CLK}$,

$$\theta_{out1} = -\theta_{RF} + n \cdot \theta_{CLK1} \qquad (5)$$

Assuming that the phase of the output signal of the filter 13 at the time $t_1 < t \leq t_2$ is $\theta_{out2}$, the phase $\theta_{out2}$ is represented by the following expression (6) or (7). That is, when the product $nf_{CLK}$ is less than or equal to the frequency $f_{RF}$ of the frequency-detection target signal, the phase $\theta_{out2}$ is represented by the expression (6). In addition, when the product $nf_{CLK}$ is larger than the frequency $f_{RF}$ of the frequency-detection target signal, the phase $\theta_{out2}$ is represented

by the expression (7).

In the case where $f_{RF} \geqq n \cdot f_{CLK}$,

$$\theta_{out2} = \theta_{RF} - n \cdot \theta_{CLK2} \qquad (6)$$

In the case where $f_{RF} < n \cdot f_{CLK}$,

$$\theta_{out2} = -\theta_{RF} + n \cdot \theta_{CLK2} \qquad (7)$$

In the time period of time $t_0 \leq t \leq t_1$, the filter 13 outputs a signal with the frequency $f_{out}$ and the phase $\theta_{out1}$ to the frequency calculation circuit 14.

In the time period of time $t_1 < t \leq t_2$, the filter 13 outputs a signal with the frequency $f_{out}$ and the phase $\theta_{out2}$ to the frequency calculation circuit 14.

Since $\theta_{CLK1} \neq \theta_{CLK2}$, the phase $\theta_{out1}$ of the output signal of the filter 13 at the time $t_0 \leq t \leq t_1$ is different from the phase $\theta_{out2}$ of the output signal of the filter 13 at the time $t_1 < t \leq t_2$.

The filter 13 is provided to prevent a malfunction of the frequency calculation circuit 14 due to inclusion of a plurality of frequency components in a signal input to the frequency calculation circuit 14, or a failure of the frequency calculation circuit 14 due to input of a high-power frequency component to the frequency calculation circuit 14.

In a case where a frequency component other than the frequency $f_{out}$ among the plurality of frequency components included in the output signal of the S/H circuit 12 is an inoperable frequency component in the frequency calculation circuit 14, and the frequency component other than the frequency $f_{out}$ does not cause the malfunction of the frequency calculation circuit 14, the frequency detection circuit 3 does not need to include the filter 13.

In addition, in a case where the power of the frequency component other than the frequency $f_{out}$ is lower than the power that causes the failure of the frequency calculation circuit 14, the frequency detection circuit 3 does not need to include the filter 13.

Since the frequency detection circuit 3 may not include the filter 13, in the present specification, the output signal of the filter 13 at the time $t_0 \leq t \leq t_1$ may be referred to as "first sampling signal" similarly to the output signal of the S/H circuit 12.

Furthermore, in the present specification, the output signal of the filter 13 at the time $t_1 < t \leq t_2$ may be referred to as "second sampling signal" similarly to the output signal of the S/H circuit 12.

When receiving the first sampling signal and the second sampling signal from the S/H circuit 12 via the filter 13, the frequency calculation circuit 14 calculates the phase difference $\theta_{out2}-\theta_{out1}$ or the phase difference $\theta_{out1}-\theta_{out2}$ between the first sampling signal and the second sampling signal.

The frequency calculation circuit 14 calculates the frequency $f_{RF}$ of the frequency-detection target signal on the basis of the phase difference $\theta_{out2}-\theta_{out1}$ or the phase difference $\theta_{out1}-\theta_{out2}$.

The frequency calculation circuit 14 outputs a signal indicating the frequency $f_{RF}$ of the frequency-detection target signal to the outside of the device.

Hereinafter, a process of calculating the frequency $f_{RF}$ by the frequency calculation circuit 14 will be specifically described.

When receiving the first sampling signal from the S/H circuit 12 via the filter 13, the quantizer 21 quantizes the first sampling signal that is an analog signal. The quantized first sampling signal is a digital signal.

The quantizer 21 outputs the quantized first sampling signal to each of the first frequency calculation circuit 22 and the phase calculation circuit 23.

When receiving the second sampling signal from the S/H circuit 12 via the filter 13, the quantizer 21 quantizes the second sampling signal that is an analog signal. The quantized second sampling signal is a digital signal.

The quantizer 21 outputs the quantized second sampling signal to each of the first frequency calculation circuit 22 and the phase calculation circuit 23.

When receiving the quantized first sampling signal from the quantizer 21, the first frequency calculation circuit 22 calculates the frequency $f_{out}$ of the first sampling signal by, for example, performing FFT on the quantized first sampling signal, and outputs a signal indicating the frequency $f_{out}$ to the second frequency calculation circuit 26.

When receiving the quantized second sampling signal from the quantizer 21, the first frequency calculation circuit 22 calculates the frequency $f_{out}$ of the second sampling signal by, for example, performing FFT on the quantized second sampling signal, and outputs a signal indicating the frequency $f_{out}$ to the second frequency calculation circuit 26.

Since the frequency $f_{out}$ of the first sampling signal and the frequency $f_{out}$ of the second sampling signal are the same, the first frequency calculation circuit 22 can calculate either the frequency $f_{out}$ of the first sampling signal or the frequency $f_{out}$ of the second sampling signal.

When receiving the quantized first sampling signal from the quantizer 21, the phase calculation circuit 23 calculates the phase $\theta_{out1}$ of the first sampling signal by, for example, performing FFT on the quantized first sampling signal, and outputs a signal indicating the phase $\theta_{out1}$ to the phase-difference calculation circuit 24.

When receiving the quantized second sampling signal from the quantizer 21, the phase calculation circuit 23 calculates the phase $\theta_{out2}$ of the second sampling signal by, for example, performing FFT on the quantized second sampling signal, and outputs a signal indicating the phase $\theta_{out2}$ to the phase-difference calculation circuit 24.

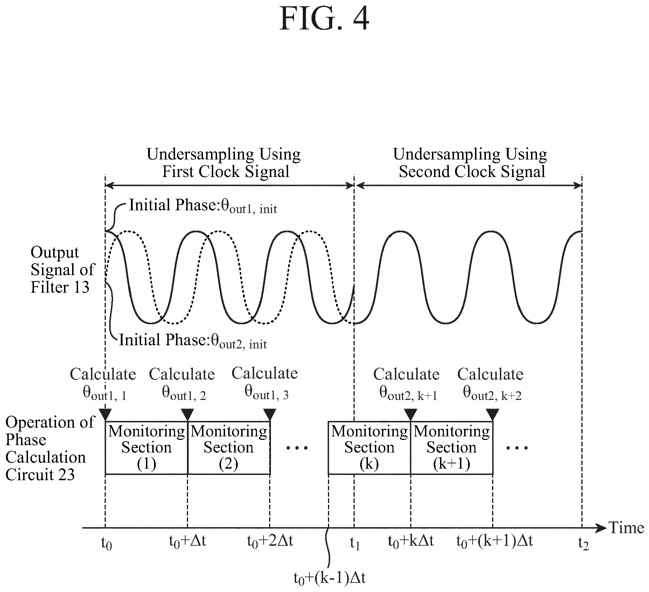

FIG. 4 is an explanatory diagram illustrating an output signal of the filter 13 and an operation of the phase calculation circuit 23.

In FIG. 4, the horizontal axis represents a time.

In a time period of time to $\leq$ t $\leq$ t$_1$, the S/H circuit 12 undersamples the signal subjected to the power amplification by the amplifier 2 in synchronization with the first clock signal with the phase of $\theta_{CLK1}$, and the filter 13 outputs a signal with the frequency $f_{out}$ and the phase $\theta_{out1}$ to the frequency calculation circuit 14.

In FIG. 4, the initial phase of the phase $\theta_{out1}$ of the output signal of the filter 13 is represented as $\theta_{out1, init}$.

In a time period of time $t_1 < t \leq t_2$, the S/H circuit 12 undersamples the signal subjected to the power amplification by the amplifier 2 in synchronization with the second clock signal with the phase of $\theta_{CLK2}$, and the filter 13 outputs a signal with the frequency $f_{out}$ and the phase $\theta_{out2}$ to the frequency calculation circuit 14.

In FIG. 4, the initial phase of the phase $\theta_{out2}$ of the output signal of the filter 13 is represented as $\theta_{out2, init}$.

The phase calculation circuit 23 monitors the quantized first sampling signal in each of a plurality of monitoring sections shorter than the time period (to $\leq$ t $\leq$ t$_1$) in which the quantized first sampling signal is output from the quantizer 21, and calculates the phase $\theta_{out1}$ at the start time of each monitoring section.

In addition, the phase calculation circuit 23 monitors the quantized second sampling signal in each of a plurality of monitoring sections shorter than the time period ($t_1 < t \leq t_2$) in which the quantized second sampling signal is output from the quantizer 21, and calculates the phase $\theta_{out2}$ at the start time of each monitoring section.

In the example of FIG. 4, the period of each of a monitoring section (1), a monitoring section (2),..., a monitoring section (k), a monitoring section (k+1)... has a time duration of $\Delta t$. k is an integer larger than or equal to three. The time duration $\Delta t$ can be stored in the memory of the phase calculation circuit 23 or can be given to the phase calculation circuit 23 from the outside of the device, for example.

The time $t_1$ is between a start time $t_0 + (k-1)\Delta t$ of the monitoring section (k) and an end time $t_0 + k\Delta t$ of the monitoring section (k), and the monitoring section (k) extends over the time $t_1$. In a case where the monitoring section (k) extends over the time $t_1$, the output signal of the filter 13 in the monitoring section (k) is discontinuous, and thus the phase calculation circuit 23 cannot correctly calculate the phase $\theta_{out2}$ at the start time of the monitoring section (k). Consequently, in the example of FIG. 4, the phase calculation circuit 23 does not calculate a phase $\theta_{out2, k}$ at the start time of the monitoring section (k).

When phases $\theta_{out1, 1}$, $\theta_{out1, 2}$, $\theta_{out1, 3}$... are each calculated in the plurality of monitoring sections shorter than the time period (to $\leq$ t $\leq$ t$_1$) in which the first sampling signal is output, the phase calculation circuit 23 outputs, as a signal indicating the phase $\theta_{out1}$, a signal indicating an average value of the phases $\theta_{out1, 1}$, $\theta_{out1, 2}$, $\theta_{out1, 3}$... to the phase-difference calculation circuit 24. The phase calculation circuit 23 can output a signal indicating any one of the phases $\theta_{out1, 1}$, $\theta_{out1, 2}$, $\theta_{out1, 3}$... to the phase-difference calculation circuit 24 instead of the average value of the phases $\theta_{out1, 1}$, $\theta_{out1, 2}$, $\theta_{out1, 3}$....

When phases $\theta_{out2, k+1}$, $\theta_{out2, k+2}$... are each calculated in the plurality of monitoring sections shorter than the time period (time $t_1 < t \leq t_2$) in which the second sampling signal is output, the phase calculation circuit 23 outputs, as a signal indicating the phase $\theta_{out2}$, a signal indicating an average value of the phases $\theta_{out2, k+1}$, $\theta_{out2, k+2}$... to the phase-difference calculation circuit 24. The phase calculation circuit 23 can output a signal indicating any one of the phases $\theta_{out2, k+1}$, $\theta_{out2, k+2}$... to the phase-difference calculation circuit 24 instead of the average value of the phases $\theta_{out2, k+1}$, $\theta_{out2, k+2}$....

When receiving a signal indicating the time to from the phase control circuit 27, the phase-difference calculation circuit 24 stores the phase $\theta_{out1}$ of the first sampling signal indicated by the signal output from the phase calculation circuit 23 in the memory of the phase-difference calculation circuit 24.

When receiving a signal indicating the time $t_1$ from the phase control circuit 27, the phase-difference calculation circuit 24 stores the phase $\theta_{out2}$ of the second sampling signal indicated by the signal output from the phase calculation circuit 23 in the memory of the phase-difference calculation circuit 24.

The phase-difference calculation circuit 24 calculates the phase difference $\theta_{out2}-\theta_{out1}$ or $\theta_{out1}-\theta_{out2}$ between the first sampling signal and the second sampling signal from the phase $\theta_{out1}$ of the first sampling signal stored in the memory and the phase $\theta_{out2}$ of the second sampling signal stored in the memory. Here, for convenience of description, it is assumed that the phase-difference calculation circuit 24 calculates the phase difference $\theta_{out2}-\theta_{out1}$.

The phase-difference $\theta_{out2}-\theta_{out1}$ calculated by the phase-difference calculation circuit 24 is represented by the following expression (8) or (9). That is, when the product $nf_{CLK}$ is less than or equal to the frequency $f_{RF}$ of the frequency-detection target signal, the phase difference $\theta_{out2}-\theta_{out1}$ is represented by the expression (8). In addition, when the product

$nf_{CLK}$ is larger than the frequency $f_{RF}$ of the frequency-detection target signal, the phase difference $\theta_{out2}-\theta_{out1}$ is represented by the expression (9).

In the case where $f_{RF} \geqq n \cdot f_{CLK}$,

$$\theta_{out2} - \theta_{out1} = n(\theta_{CLK1} - \theta_{CLK2}) \qquad (8)$$

In the case where $f_{RF} < n \cdot f_{CLK}$,

$$\theta_{out2} - \theta_{out1} = n(\theta_{CLK2} - \theta_{CLK1}) \qquad (9)$$

The phase-difference calculation circuit 24 outputs a signal indicating the phase difference $\theta_{out2}-\theta_{out1}$ to the degree calculation circuit 25.

When receiving the signal indicating the phase difference $\theta_{out2}-\theta_{out1}$ from the phase-difference calculation circuit 24, the degree calculation circuit 25 calculates the degree n of undersampling using the phase difference $\theta_{out2}-\theta_{out1}$ indicated by the signal and the phase difference $\theta_{CLK2}-\theta_{CLK1}$. The degree n of undersampling is an integer satisfying the following expression (10).

$$f_{RF} = |n \cdot f_{CLK} \pm f_{out}| \qquad (10)$$

The degree n calculated by the degree calculation circuit 25 is represented by the following expression (11) or (12). That is, when the product $nf_{CLK}$ is less than or equal to the frequency $f_{RF}$ of the frequency-detection target signal, the degree n is represented by the expression (11). In addition, when the product $nf_{CLK}$ is larger than the frequency $f_{RF}$ of the frequency-detection target signal, the degree n is represented by the expression (12).

The phase difference $\theta_{CLK2}-\theta_{CLK1}$ is a phase difference between the phase $\theta_{CLK1}$ of the first clock signal and the phase $\theta_{CLK2}$ of the second clock signal, and is stored in the memory of the degree calculation circuit 25.

In the case where $f_{RF} \geqq n \cdot f_{CLK}$,

$$n = - \frac{\theta_{out2}-\theta_{out1}}{\theta_{CLK2}-\theta_{CLK1}} \qquad (11)$$

In the case where $f_{RF} < n \cdot f_{CLK}$,

$$n = \frac{\theta_{out2}-\theta_{out1}}{\theta_{CLK2}-\theta_{CLK1}} \qquad (12)$$

In the frequency calculation circuit 14 illustrated in FIG. 2, the degree n calculated by the phase-difference calculation circuit 24 is the degree of undersampling. However, this is merely an example, and the degree n calculated by the phase-difference calculation circuit 24 can be the degree of the first clock signal or the degree of the second clock signal. The degree of the first clock signal or the degree of the second clock signal is also represented by the expression (11) or (12).

When the product $nf_{CLK}$ is less than or equal to the frequency $f_{RF}$, the second frequency calculation circuit 26 calculates the frequency $f_{RF}$ of the frequency-detection target signal by substituting the frequency $f_{out}$ indicated by the signal output from the first frequency calculation circuit 22, the frequency $f_{CLK}$, and the degree n into the following expression (13).

$$f_{RF} = f_{out} + n \cdot f_{CLK} \qquad (13)$$

When the product $nf_{CLK}$ is larger than the frequency $f_{RF}$, the second frequency calculation circuit 26 calculates the frequency $f_{RF}$ of the frequency-detection target signal by substituting the frequency $f_{out}$ indicated by the signal output from the first frequency calculation circuit 22, the frequency $f_{CLK}$, and the degree n into the following expression (14).

$$f_{RF} = -f_{out} + n \cdot f_{CLK} \qquad (14)$$

The second frequency calculation circuit 26 outputs a signal indicating the frequency $f_{RF}$ of the frequency-detection target signal to the outside of the device.

Hereinafter, a specific process of calculating the degree n by the degree calculation circuit 25 and a specific process of calculating the frequency $f_{RF}$ by the second frequency calculation circuit 26 will be described.

In general, in a case where the phase of any signal is calculated, the result of the phase calculation is represented by a value larger than or equal to 0° and less than 360°. For example, when the phase difference $\theta_{out2}$-$\theta_{out1}$ is 370°, the phase-difference calculation circuit 24 calculates 10° as the phase difference $\theta_{out2}$-$\theta_{out1}$. As a result, there is an ambiguity that the calculation result of the phase-difference calculation circuit 24 is calculated as 10° even if the phase difference $\theta_{out2}$-$\theta_{out1}$ is 370°. Consequently, in order for the second frequency calculation circuit 26 to correctly calculate the frequency $f_{RF}$, the phase $\theta_{CLK1}$ of the first clock signal and the phase $\theta_{CLK2}$ of the second clock signal need to be appropriately set.

For example, it is assumed that the frequency range that can be detected by the frequency detection circuit 3 is 3 to 10 GHz, and $f_{CLK}$ = 1 GHz, $\theta_{CLK1}$ = 0°, and $\theta_{CLK2}$ = 10° are set.

At this time, it is assumed that the frequency $f_{out}$ calculated by the first frequency calculation circuit 22 is 0.1 GHz and the phase difference $\theta_{out2}$-$\theta_{out1}$ calculated by the phase-difference calculation circuit 24 is 330°.

In view of the ambiguity of the phase difference $\theta_{out2}$-$\theta_{out1}$, the phase difference $\theta_{out2}$-$\theta_{out1}$ is 330° + β360°, where β is an integer.

When the phase difference $\theta_{out2}$-$\theta_{out1}$ = 330° + β360° and the phase difference $\theta_{CLK2}$-$\theta_{CLK1}$ = 10° are substituted into the expression (11), the degree n = -33 - 36β is obtained. In addition, when the degree n = -33 - 36 β, the frequency $f_{out}$ = 0.1 GHz, and the frequency $f_{CLK}$ = 1 GHz are substituted into the expression (13), the frequency $f_{RF}$ = (-33 - 36β + 0.1) GHz is obtained.

β that satisfies 3 to 10 GHz, which is a frequency range that can be detected by the frequency detection circuit 3, at the frequency $f_{RF}$ = (-33 - 36β + 0.1) GHz is only -1. The degree when β = -1 is n = -33 - 36 × (-1) = 3. Consequently, the frequency $f_{RF}$ = 3.1 GHz when the degree n = 3 is calculated by the expression (13).

When the phase difference $\theta_{out2}$-$\theta_{out1}$ = 330° + β360° and the phase difference $\theta_{CLK2}$-$\theta_{CLK1}$ = 10° are substituted into the expression (12) instead of the expression (11), the degree n = 33 + 36β is obtained. Furthermore, when the degree n = 33 + 36β, the frequency $f_{out}$ = 0.1 GHz, and the frequency $f_{CLK}$ = 1 GHz are substituted into the expression (14), the frequency $f_{RF}$ = (33 + 36β - 0.1) GHz is obtained.

There is no β that satisfies 3 to 10 GHz, which is a frequency range that can be detected by the frequency detection circuit 3, at the frequency $f_{RF}$ = (33 + 36β - 0.1) GHz.

Consequently, the degree n = 3 and the frequency $f_{RF}$ = 3.1 GHz are uniquely determined.

Next, it is assumed that $f_{CLK}$ = 1 GHz, $\theta_{CLK1}$ = 0°, and $\theta_{CLK2}$ = 90° are set.

At this time, it is assumed that the frequency $f_{out}$ calculated by the first frequency calculation circuit 22 is 0.1 GHz and the phase difference $\theta_{out2}$-$\theta_{out1}$ calculated by the phase-difference calculation circuit 24 is 90°.

In view of the ambiguity of the phase difference $\theta_{out2}$-$\theta_{out1}$, the phase difference $\theta_{out2}$-$\theta_{out1}$ is 90° + β360°.

When the phase difference $\theta_{out2}$-$\theta_{out1}$ = 90° + β360° and the phase difference $\theta_{CLK2}$-$\theta_{CLK1}$ = 90° are substituted into the expression (11), the degree n = -1 - 4β is obtained. Furthermore, when the degree n = -1 - 4β, the frequency $f_{out}$ = 0.1 GHz, and the frequency $f_{CLK}$ = 1 GHz are substituted into the expression (13), the frequency $f_{RF}$ = (-1 - 4β + 0.1) GHz is obtained.

β that satisfies 3 to 10 GHz, which is a frequency range that can be detected by the frequency detection circuit 3, at the frequency $f_{RF}$ = (-1 - 4β + 0.1) GHz is -1 and -2. The degree when β = -1 is n = -1 - 4 × (-1) = 3, and the degree when β = -2 is n = -1 - 4 × (-2) = 7. Consequently, the frequency $f_{RF}$ = 3.1 GHz when the degree n = 3 is calculated, and $f_{RF}$ = 7.1 GHz when the degree n = 7 is calculated by the expression (13).

When the phase difference $\theta_{out2}$-$\theta_{out1}$ = 90° + β360° and the phase difference $\theta_{CLK2}$-$\theta_{CLK1}$ = 90° are substituted into the expression (12) instead of the expression (11), the degree n = 1 + 4β is obtained. Furthermore, when the degree n = 1 + 4β, the frequency $f_{out}$ = 0.1 GHz, and the frequency $f_{CLK}$ = 1 GHz are substituted into the expression (14), the frequency $f_{RF}$ = (1 + 4β - 0.1) GHz is obtained.

β that satisfies 3 to 10 GHz, which is a frequency range that can be detected by the frequency detection circuit 3, at the frequency $f_{RF}$ = (1 + 4β - 0.1) GHz is 1 and 2. The degree when β = 1 is n = 1 + 4 × 1 = 5, and the degree when β = 2 is n = 1 + 4 × 2 = 9. Consequently, the frequency $f_{RF}$ = 4.9 GHz when the degree n = 5 is set, and $f_{RF}$ = 8.9 GHz when the degree n = 9 is calculated by the expression (14).

In a case where $f_{CLK}$ = 1 GHz, $\theta_{CLK1}$ = 0°, and $\theta_{CLK2}$ = 90° are set, a plurality of degrees n and a plurality of frequencies $f_{RF}$ are calculated, and thus each of the degree n and the frequency $f_{RF}$ is not uniquely determined. Since each of the degree n and the frequency $f_{RF}$ is not uniquely determined, each of the phase $\theta_{CLK1}$ and the phase $\theta_{CLK2}$ is not appropriately set.

As described above, unless each of the phase $\theta_{CLK1}$ and the phase $\theta_{CLK2}$ is appropriately set, the frequency $f_{RF}$ is not uniquely determined. In order to uniquely determine the frequency $f_{RF}$, in a case where the phase range that can be detected by the phase-difference calculation circuit 24 is $\theta_1$ to $\theta_2$, each of the phase $\theta_{CLK1}$ and the phase $\theta_{CLK2}$ needs to be set to satisfy the following expression (15). The range of $\theta_1$ to $\theta_2$ is, for example, 0° to 360°.

$$\theta_{CLK2} - \theta_{CLK1} < \frac{\theta_2 - \theta_1}{round\left(\frac{f_{RF}}{f_{CLK}}, 0\right)} \qquad (15)$$

In the expression (15), round (x, y) is a function for rounding a numerical value x, and y is the number of decimal places to which the numerical value x is rounded.

The memory of the phase control circuit 27 stores each of the phase $\theta_{CLK1}$ and the phase $\theta_{CLK2}$ set to satisfy the expression (15).

When outputting a signal indicating the time to to the phase-difference calculation circuit 24, the phase control circuit 27 outputs a signal indicating the phase $\theta_{CLK1}$ stored in the memory to the signal source 11.

When outputting a signal indicating the time $t_1$ to the phase-difference calculation circuit 24, the phase control circuit 27 outputs a signal indicating the phase $\theta_{CLK2}$ stored in the memory to the signal source 11.

In addition, the memory of the degree calculation circuit 25 stores the phase difference $\theta_{CLK2}$-$\theta_{CLK1}$ between the phase $\theta_{CLK1}$ set to satisfy the expression (15) and the phase $\theta_{CLK2}$ set to satisfy the expression (15).

In the frequency detection circuit 3 illustrated in FIG. 1, each of the phase $\theta_{CLK1}$ and the phase $\theta_{CLK2}$ that are set to satisfy the expression (15) is stored in the memory of the phase control circuit 27. However, this is merely an example, and the phase control circuit 27 can calculate each of the phase $\theta_{CLK1}$ and the phase $\theta_{CLK2}$ that satisfy the expression (15), or each of the phase $\theta_{CLK1}$ and the phase $\theta_{CLK2}$ that are set to satisfy the expression (15) can be provided to the phase control circuit 27 from the outside of the device.

In the first embodiment described above, the frequency detection circuit 3 includes the signal source 11 that outputs a first clock signal and a second clock signal that has the same frequency as the first clock signal and a different phase from the first clock signal, the S/H circuit 12 that undersamples a frequency-detection target signal using the first clock signal output from the signal source 11 and outputs a first sampling signal indicating a result of undersampling, and undersamples the frequency-detection target signal using the second clock signal output from the signal source 11 and outputs a second sampling signal indicating a result of undersampling, and the frequency calculation circuit 14 that calculates a phase difference between the first sampling signal output from the S/H circuit 12 and the second sampling signal output from the S/H circuit 12 and calculates the frequency of the frequency-detection target signal on the basis of the phase difference. As a result, even if the frequency of the frequency-detection target signal is high, the frequency detection circuit 3 can calculate the frequency of the frequency-detection target signal by the same circuit as when the frequency is low.

In the frequency calculation circuit 14 illustrated in FIG. 2, the phase-difference calculation circuit 24 outputs a signal indicating the phase difference $\theta_{out2}$-$\theta_{out1}$ to the degree calculation circuit 25. However, this is merely an example, and the phase-difference calculation circuit 24 can calculate the phase difference $\theta_{out1}$-$\theta_{out2}$ and output a signal indicating the phase difference $\theta_{out1}$-$\theta_{out2}$ to the degree calculation circuit 25.

In a case where the phase-difference calculation circuit 24 outputs the signal indicating the phase difference $\theta_{out1}$-$\theta_{out2}$ to the degree calculation circuit 25, the degree n calculated by the degree calculation circuit 25 is represented by the expression in which the right side of the expression (11) is multiplied by -1 or the expression in which the right side of the expression (12) is multiplied by -1.

In the reception device illustrated in FIG. 1, the amplifier 2, the S/H circuit 12, and the filter 13 are provided between the output terminal 1a of the antenna 1 and the input terminal 14a of the frequency calculation circuit 14. The reception device can include, in addition to the amplifier 2, the S/H circuit 12, and the filter 13, a frequency conversion circuit that converts the frequency of a reception signal between the output terminal 1a of the antenna 1 and the input terminal 14a of the frequency calculation circuit 14. As the frequency conversion circuit, for example, a frequency divider, a multiplier, a mixer, or an S/H circuit can be used.

In the frequency calculation circuit 14 illustrated in FIG. 2, the phase control circuit 27 controls each of the signal source 11 and the phase-difference calculation circuit 24. However, this is merely an example, and each of the signal source 11 and the phase-difference calculation circuit 24 can incorporate a clock, and the signal source 11 can oscillate the first clock signal at the time to and the second clock signal at the time $t_1$. In addition, the phase-difference calculation circuit 24 can store the phase $\theta_{out1}$ of the first sampling signal indicated by the signal output from the phase calculation circuit 23 in the memory of the phase-difference calculation circuit 24 at the time $t_0$, and store the phase $\theta_{out2}$ of the second sampling signal indicated by the signal output from the phase calculation circuit 23 in the memory of the phase-difference calculation circuit 24 at the time $t_1$.

In a case where each of the signal source 11 and the phase-difference calculation circuit 24 incorporates a clock and manages the time to and the time $t_1$, it is not necessary to mount the phase control circuit 27 in the frequency calculation circuit 14.

In the frequency calculation circuit 14 illustrated in FIG. 2, the phase control circuit 27 controls the signal source 11 in such a manner that the signal source 11 temporally continuously generates the first clock signal and the second clock signal. However, this is merely an example, and the phase control circuit 27 can control the signal source 11 in such a manner that the signal source 11 generates the second clock signal after a predetermined time elapses from the generation of the first clock signal.

The pass band of the filter 13 illustrated in FIG. 3 is a pass band in which a frequency component with the lowest frequency $f_{S/H}$ among a plurality of frequency components included in the output signal of the S/H circuit 12 is passed. However, the frequency $f_{out}$ of the frequency component included in the output signal of the filter 13 is only required to be a frequency different from the frequency $f_{RF}$. Consequently, the pass band of the filter 13 can be a pass band in which one frequency component other than the frequency component with the lowest frequency $f_{S/H}$ among the plurality of frequency components included in the output signal of the S/H circuit 12 is passed.

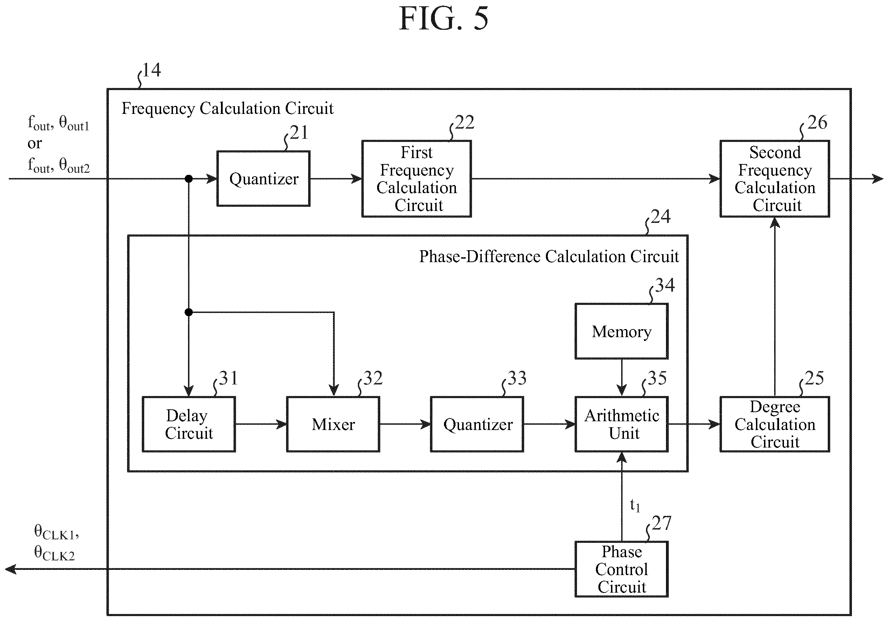

In the frequency calculation circuit 14 illustrated in FIG. 2, each of the quantized first sampling signal and the quantized second sampling signal that are output from the quantizer 21 is a digital signal, and each of the phase calculation circuit 23 and the phase-difference calculation circuit 24 is a digital circuit that handles the digital signal. However, this is merely an example, and for example, a part of the phase-difference calculation circuit 24 that calculates the phase difference $\theta_{out2}-\theta_{out1}$ can be configured with an analog circuit as illustrated in FIG. 5.

FIG. 5 is a configuration diagram illustrating another frequency calculation circuit 14 of the frequency detection circuit 3 according to the first embodiment. In FIG. 5, the same reference numerals as those in FIG. 2 denote the same or corresponding parts, and thus description thereof is omitted.

The phase-difference calculation circuit 24 includes a delay circuit 31, a mixer 32, a quantizer 33, a memory 34, and an arithmetic unit 35. Each of the delay circuit 31, the mixer 32, and the quantizer 33 is an analog circuit, and each of the memory 34 and the arithmetic unit 35 is a digital circuit.

An output signal of the filter 13 is input to each of the quantizer 21, the delay circuit 31, and the mixer 32.

The delay circuit 31 is a circuit that delays the output signal of the filter 13 by a delay time ti-to.

The mixer 32 mixes the signal delayed by the delay circuit 31 and the output signal of the filter 13, thereby outputting an analog signal indicating the phase difference between the two signals to the quantizer 33.

When the output signal of the filter 13 input to the mixer 32 is, for example, an output signal at the time $t_1$, the signal delayed by the delay circuit 31 corresponds to the output signal of the filter 13 at the time to.

The analog signal output from the mixer 32 is not a signal indicating the phase difference $\theta_{out2}-\theta_{out1}$, but is a signal having a correspondence relationship with the phase difference $\theta_{out2}-\theta_{out1}$.

The quantizer 33 generates a digital signal by quantizing the output signal of the mixer 32 and outputs the digital signal to the arithmetic unit 35.

The memory 34 is a storage medium that stores a correspondence relationship between the digital signal output from the quantizer 33 and the phase difference $\theta_{out2}-\theta_{out1}$.

The arithmetic unit 35 is implemented by, for example, an FPGA.

When receiving a signal indicating the time $t_1$ from the phase control circuit 27, the arithmetic unit 35 refers to the correspondence relationship stored in the memory 34 and determines the phase difference $\theta_{out2}-\theta_{out1}$ corresponding to the digital signal output from the quantizer 33.

The arithmetic unit 35 outputs a signal indicating the phase difference $\theta_{out2}-\theta_{out1}$ to the degree calculation circuit 25.

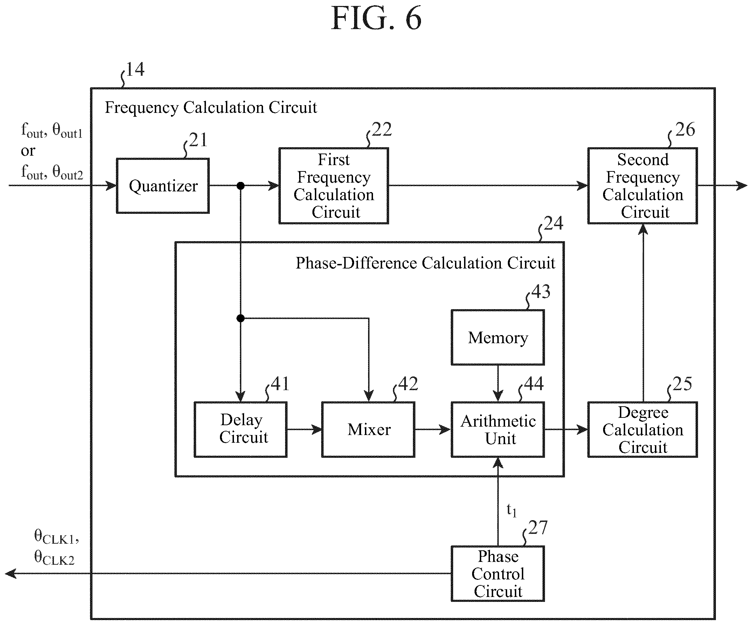

In the frequency calculation circuit 14 illustrated in FIG. 5, a part of the phase-difference calculation circuit 24 is configured with an analog circuit. However, this is merely an example, and the phase-difference calculation circuit 24 may be configured with a digital circuit as illustrated in FIG. 6.

FIG. 6 is a configuration diagram illustrating yet another frequency calculation circuit 14 of the frequency detection circuit 3 according to the first embodiment. In FIG. 6, the same reference numerals as those in FIGS. 2 and 5 denote the same or corresponding parts, and thus description thereof is omitted.

The phase-difference calculation circuit 24 includes a delay circuit 41, a mixer 42, a memory 43, and an arithmetic unit 44. Each of the delay circuit 41, the mixer 42, the memory 43, and the arithmetic unit 44 is a digital circuit.

An output signal of the quantizer 21 is input to each of the delay circuit 41 and the mixer 42.

The delay circuit 41 is implemented by, for example, an FPGA.

The delay circuit 41 is a circuit that delays the output signal of the quantizer 21 by a delay time ti-to.

The mixer 42 is implemented by, for example, an FPGA.

The mixer 42 mixes the signal delayed by the delay circuit 41 and the output signal of the quantizer 21, thereby outputting a digital signal indicating the phase difference between the two signals to the arithmetic unit 44.

When the output signal of the quantizer 21 input to the mixer 42 is, for example, an output signal at the time $t_1$, the signal delayed by the delay circuit 41 corresponds to the output signal of the quantizer 21 at the time to.

The digital signal output from the mixer 42 is not a signal indicating the phase difference $\theta_{out2}-\theta_{out1}$, but is a signal having a correspondence relationship with the phase difference $\theta_{out2}-\theta_{out1}$.

The memory 43 is a storage medium that stores a correspondence relationship between the digital signal output from the mixer 42 and the phase difference $\theta_{out2}-\theta_{out1}$.

The arithmetic unit 44 is implemented by, for example, an FPGA.

When receiving a signal indicating the time $t_1$ from the phase control circuit 27, the arithmetic unit 44 refers to the correspondence relationship stored in the memory 43 and determines the phase difference $\theta_{out2}-\theta_{out1}$ corresponding to the digital signal output from the mixer 42.

The arithmetic unit 44 outputs a signal indicating the phase difference $\theta_{out2}-\theta_{out1}$ to the degree calculation circuit 25.

In the frequency calculation circuit 14 illustrated in FIG. 2, the degree calculation circuit 25 calculates the degree n that is an integer. In a case where the degree n calculated by the degree calculation circuit 25 is a decimal number close to an integer due to variations in circuit performance or the like, the degree calculation circuit 25 can change the decimal number close to an integer to an integer by, for example, rounding the decimal place.

In the reception device illustrated in FIG. 1, one frequency component is included in a signal received by the antenna 1, and the frequency detection circuit 3 detects the frequency $f_{RF}$ of one frequency component. However, this is merely an example, and a plurality of frequency components can be included in the signal received by the antenna 1, and the frequency detection circuit 3 can detect each frequencies $f_{RF}$ of the plurality of frequency components.

In a case where the signal received by the antenna 1 includes a plurality of frequency components, the output signal of the filter 13 includes a plurality of frequency components.

For example, in a case where two frequency components are included in the signal received by the antenna 1, the filter 13 outputs a signal that includes, for example, a frequency component with the lowest frequency $f_{S/H}$ and a frequency component with the highest frequency $f_{S/H}$ among the plurality of frequency components included in the output signal of the S/H circuit 12 to the frequency calculation circuit 14.

When receiving the signal including two frequency components from the filter 13, the frequency calculation circuit 14 calculates each frequencies $f_{RF}$ of the two frequency components by performing a similar process on each of the frequency components.

In the reception device illustrated in FIG. 1, in a case where a situation occurs in which the frequency $f_{RF}$ is an integral multiple of the Nyquist frequency (hereinafter, referred to as "event (1)"), if the S/H circuit 12 performs under-sampling, the frequency $f_{out}$ becomes direct current (DC) and no phase information is present. As a result, in a case where the event (1) occurs, the second frequency calculation circuit 26 cannot determine the frequency $f_{RF}$.

If the frequency $f_{out}$ calculated by the first frequency calculation circuit 22 is DC, for example, the second frequency calculation circuit 26 can notify the outside of the device that the frequency $f_{RF}$ cannot be determined.

In addition, if the frequency $f_{out}$ calculated by the first frequency calculation circuit 22 is DC, for example, the second frequency calculation circuit 26 can notify the signal source 11 that the frequency $f_{RF}$ cannot be determined, and the signal source 11 can prevent the event (1) by changing the frequency $f_{CLK}$.

In a case where a plurality of frequency components are included in the signal (hereinafter, referred to as "reception signal") received by the antenna 1, an event (2) may occur.

The event (2) is a situation in which frequencies of a plurality of frequency components included in the output signal of the S/H circuit 12 corresponding to one frequency component of the plurality of frequency components included in the reception signal and frequencies of a plurality of frequency components included in the output signal of the S/H circuit 12 corresponding to another frequency component included in the reception signal are the same in the first Nyquist zone.

The filter 13 passes only a signal of a frequency component with the lowest frequency $f_{S/H}$ among the plurality of frequency components included in the output signal of the S/H circuit 12. The signal with the lowest frequency component is a signal in the first Nyquist zone.

In a case where the event (2) occurs, since the phases of the plurality of frequency components included in the filter 13 cannot be represented by the expressions (4) to (7), the degree calculation circuit 25 cannot calculate the degree n corresponding to each of the plurality of frequencies $f_{RF}$. In a case where the event (2) occurs, the degree n calculated by the degree calculation circuit 25 may be a decimal number away from an integer. In addition, when the second frequency calculation circuit 26 calculates the frequency $f_{RF}$ on the basis of the degree n calculated by the degree calculation circuit 25, the frequency $f_{RF}$ may be a value outside a frequency detection range.

As a result, in a case where the event (2) occurs, the second frequency calculation circuit 26 cannot correctly calculate the plurality of frequencies $f_{RF}$.

In a case where the frequency calculation circuit 14 includes an evaluation circuit (not illustrated) that evaluates the degree n calculated by the degree calculation circuit 25, and the degree n calculated by the degree calculation circuit 25 is a decimal number away from an integer, or the like, the evaluation circuit can notify the outside of the device that the frequency $f_{RF}$ cannot be determined.

Furthermore, the evaluation circuit can notify the signal source 11 that the frequency $f_{RF}$ cannot be determined, and the signal source 11 can prevent the event (2) by changing the frequency $f_{CLK}$.

Second Embodiment

In a second embodiment, a reception device that includes the antenna 1, the amplifier 2, a frequency detection circuit 50, and an arithmetic circuit 52 will be described.

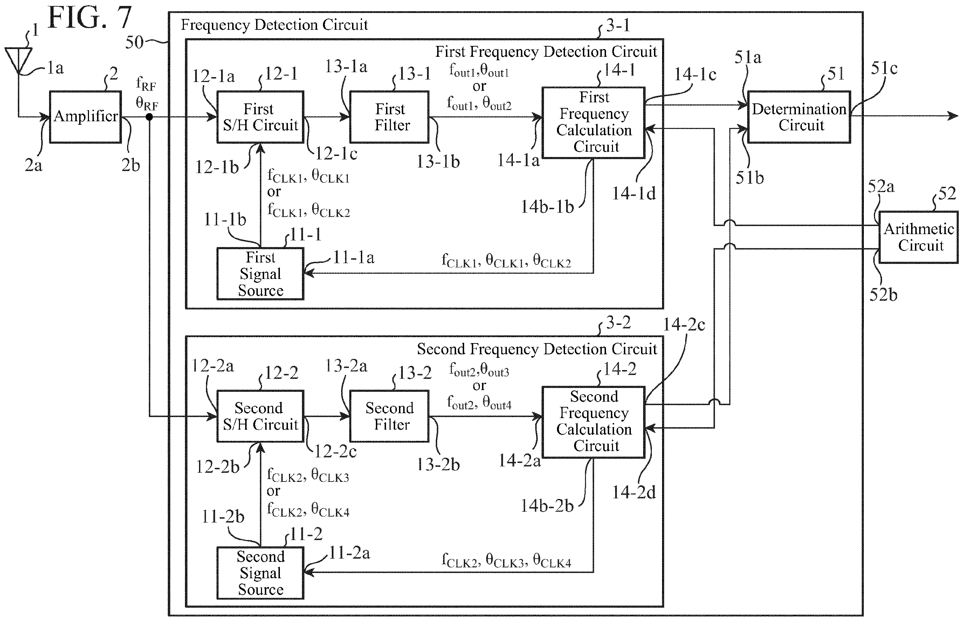

FIG. 7 is a configuration diagram illustrating a reception device according to the second embodiment. In FIG. 7, the same reference numerals as those in FIG. 1 denote the same or corresponding parts, and thus description thereof is omitted.

The frequency detection circuit 50 includes a first frequency detection circuit 3-1, a second frequency detection circuit 3-2, and a determination circuit 51.

The first frequency detection circuit 3-1 includes a first signal source 11-1, a first S/H circuit 12-1, a first filter 13-1, and a first frequency calculation circuit 14-1.

The first signal source 11-1 is the same signal source as the signal source 11 illustrated in FIG. 1, and the first S/H circuit 12-1 is the same circuit as the S/H circuit 12 illustrated in FIG. 1.

The first filter 13-1 is the same filter as the filter 13 illustrated in FIG. 1, and the first frequency calculation circuit 14-1 is the same circuit as the frequency calculation circuit 14 illustrated in FIG. 1.

A control terminal 11-1a of the first signal source 11-1 is the same control terminal as the control terminal 11a of the signal source 11 illustrated in FIG. 1, and an output terminal 11-lb of the first signal source 11-1 is the same output terminal as the output terminal 11b of the signal source 11 illustrated in FIG. 1.

An input terminal 12-1a of the first S/H circuit 12-1 is the same input terminal as the input terminal 12a of the S/H circuit 12 illustrated in FIG. 1, and a clock terminal 12-1b of the first S/H circuit 12-1 is the same clock terminal as the clock terminal 12b of the S/H circuit 12 illustrated in FIG. 1. An output terminal 12-1c of the first S/H circuit 12-1 is the same output terminal as the output terminal 12c of the S/H circuit 12 illustrated in FIG. 1.

An input terminal 13-1a of the first filter 13-1 is the same input terminal as the input terminal 13a of the filter 13 illustrated in FIG. 1, and an output terminal 13-lb of the first filter 13-1 is the same output terminal as the output terminal 13b of the filter 13 illustrated in FIG. 1.

An input terminal 14-1a of the first frequency calculation circuit 14-1 is the same input terminal as the input terminal 14a of the frequency calculation circuit 14 illustrated in FIG. 1, and a first output terminal 14-1b of the first frequency calculation circuit 14-1 is the same output terminal as the first output terminal 14b of the frequency calculation circuit 14 illustrated in FIG. 1.

A second output terminal 14-1c of the first frequency calculation circuit 14-1 is connected to a first input terminal 51a of the determination circuit 51, and an input terminal 14-1d of the first frequency calculation circuit 14-1 is connected to a first output terminal 52a of the arithmetic circuit 52 to be described later.

Consequently, the first frequency detection circuit 3-1 is a frequency detection circuit with the same configuration as frequency detection circuit 3 illustrated in FIG. 1.

Note, however, that in the second embodiment, for convenience of description, it is assumed that each of the frequency of a first clock signal and the frequency of a second clock signal, the first clock signal and the second clock signal being output from the first signal source 11-1, is $f_{CLK1}$. In addition, it is assumed that the frequency of an output signal of the first filter 13-1 is $f_{out1}$.

The second frequency detection circuit 3-2 includes a second signal source 11-2, a second S/H circuit 12-2, a second filter 13-2, and a second frequency calculation circuit 14-2.

The second frequency detection circuit 3-2 is a frequency detection circuit with the same configuration as the frequency detection circuit 3 illustrated in FIG. 1, but the frequencies of a third clock signal and a fourth clock signal that are output from the second signal source 11-2 are $f_{CLK2}$, and are different from each frequencies $f_{CLK1}$ of the first clock signal and the second clock signal. $f_{CLK1} \neq f_{CLK2}$.

The second signal source 11-2 is implemented by, for example, a DAC, a DDS, or a PLL circuit.

A control terminal 11-2a of the second signal source 11-2 is connected to a first output terminal 14-2b of the second frequency calculation circuit 14-2, and an output terminal 11-2b of the second signal source 11-2 is connected to a clock terminal 12-2b of the S/H circuit 12-2.

The second signal source 11-2 generates a third clock signal with a frequency $f_{CLK2}$ and a phase $\theta_{CLK3}$ on the basis of the frequency $f_{CLK2}$ of the third clock signal indicated by the signal output from the second frequency calculation circuit 14-2 and the phase $\theta_{CLK3}$ of the third clock signal indicated by the signal output from the second frequency calculation circuit 14-2.

In addition, the second signal source 11-2 generates a fourth clock signal with the frequency $f_{CLK2}$ and a phase $\theta_{CLK4}$ on the basis of the frequency $f_{CLK2}$ of the fourth clock signal indicated by the signal output from the second frequency calculation circuit 14-2 and the phase $\theta_{CLK4}$ of the fourth clock signal indicated by the signal output from the second frequency calculation circuit 14-2.

The frequency $f_{CLK2}$ of the third clock signal and the frequency $f_{CLK2}$ of the fourth clock signal are the same, and the phase $\theta_{CLK3}$ of the third clock signal and the phase $\theta_{CLK4}$ of the fourth clock signal are different.

In the second frequency detection circuit 3-2 illustrated in FIG. 7, the second signal source 11-2 generates the third clock signal on the basis of the phase $\theta_{CLK3}$ output from the second frequency calculation circuit 14-2, and generates the fourth clock signal on the basis of the phase $\theta_{CLK4}$ output from the second frequency calculation circuit 14-2. However, this is merely an example, and the second signal source 11-2 can generate each of the third clock signal and the fourth clock signal on the basis of a control signal or the like provided from the outside of the device.

The second S/H circuit 12-2 is implemented by, for example, a circuit that includes a changeover switch that switches between open and short-circuit of a line through which a signal subjected to the power amplification by the amplifier 2 propagates and a capacitor that stores a charge when the line is opened by the changeover switch.

An input terminal 12-2a of the second S/H circuit 12-2 is connected to the output terminal 2b of the amplifier 2, the clock terminal 12-2b of the second S/H circuit 12-2 is connected to the output terminal 11-2b of the second signal source 11-2, and an output terminal 12-2c of the second S/H circuit 12-2 is connected to an input terminal 13-2a of the second filter 13-2.

The second S/H circuit 12-2 undersamples the signal subjected to the power amplification by the amplifier 2 using the third clock signal output from the second signal source 11-2, and outputs a third sampling signal indicating a result of undersampling to the second filter 13-2.

The second S/H circuit 12-2 undersamples the signal subjected to the power amplification by the amplifier 2 using the fourth clock signal output from the second signal source 11-2, and outputs a fourth sampling signal indicating a result of undersampling to the second filter 13-2.

The second filter 13-2 is implemented by, for example, a chip inductor and a chip capacitor.

The second filter 13-2 has a predetermined pass band. The second filter 13-2 is, for example, LPF, HPF, or BPF.

The input terminal 13-2a of the second filter 13-2 is connected to the output terminal 12-2c of the second S/H circuit 12-2, and an output terminal 13-2b of the second filter 13-2 is connected to an input terminal 14-2a of the second frequency calculation circuit 14-2.

When receiving the third sampling signal from the second S/H circuit 12-2, the second filter 13-2 passes frequency components within the pass band and suppresses frequency components outside the pass band in the third sampling signal.

When receiving the fourth sampling signal from the second S/H circuit 12-2, the second filter 13-2 passes frequency components within the pass band and suppresses frequency components outside the pass band in the fourth sampling signal.

The second filter 13-2 can implement a microstrip line, a coaxial resonator, or the like depending on a pass band in which the second filter 13-2 passes frequency components or a necessary amount of suppression of frequency components by the second filter 13-2.

The input terminal 14-2a of the second frequency calculation circuit 14-2 is connected to the output terminal 13-2b of the second filter 13-2, and the first output terminal 14-2b of the second frequency calculation circuit 14-2 is connected to the control terminal 11-2a of the signal source 11.

In addition, a second output terminal 14-2c of the second frequency calculation circuit 14-2 is connected to a second input terminal 51b of the determination circuit 51, and an input terminal 14-2d of the second frequency calculation circuit 14-2 is connected to a second output terminal 52b of the arithmetic circuit 52.

The second frequency calculation circuit 14-2 calculates a phase difference $\theta_{out4}-\theta_{out3}$ or a phase difference $\theta_{out3}-\theta_{out4}$ between the third sampling signal output from the second filter 13-2 and having passed through the second filter 13-2 and the fourth sampling signal output from the second filter 13-2 and having passed through the second filter 13-2.

On the basis of the phase difference $\theta_{out4}-\theta_{out3}$ or the phase difference $\theta_{out3}-\theta_{out4}$, the second frequency calculation circuit 14-2 calculates the frequency $f_{RF}$ of the signal subjected to the power amplification by the amplifier 2 as the frequency $f_{RF}$ of the frequency-detection target signal.

The second frequency calculation circuit 14-2 outputs a signal indicating the frequency $f_{RF}$ of the frequency-detection target signal to the determination circuit 51.

In addition, the second frequency calculation circuit 14-2 outputs a signal indicating the phase $\theta_{CLK3}$ of the third clock signal or a signal indicating the phase $\theta_{CLK4}$ of the fourth clock signal to the second signal source 11-2.

The determination circuit 51 is implemented by, for example, an FPGA.

The first input terminal 51a of the determination circuit 51 is connected to the second output terminal 14-1c of the first frequency calculation circuit 14-1, and the second input terminal 51b of the determination circuit 51 is connected to the second output terminal 14-2c of the second frequency calculation circuit 14-2. An output terminal 51c of the determination circuit 51 is connected to an external circuit (not illustrated).

The determination circuit 51 determines which of the frequency calculated by the first frequency calculation circuit 14-1 and the frequency calculated by the second frequency calculation circuit 14-2 is close to the true frequency of the frequency-detection target signal.

For example, the determination circuit 51 determines which frequency is close to the true frequency of the frequency-detection target signal on the basis of the degree d calculated by the degree calculation circuit 25 of the first frequency calculation circuit 14-1 and the degree d calculated by the degree calculation circuit 25 of the second frequency calculation circuit 14-2.

The determination circuit 51 outputs a signal indicating the frequency determined to be close to the true frequency of the frequency-detection target signal to an external circuit (not illustrated).

The arithmetic circuit 52 is implemented by, for example, a computer including a central processing unit (CPU) and a memory, a microcomputer, or an FPGA.

The first output terminal 52a of the arithmetic circuit 52 is connected to the input terminal 14-1d of the first frequency calculation circuit 14-1, and the second output terminal 52b of the arithmetic circuit 52 is connected to the input terminal 14-2d of the second frequency calculation circuit 14-2.

The arithmetic circuit 52 calculates the frequencies $f_{CLK1}$ and $f_{CLK2}$ capable of preventing each of the events (1) and (2).

The arithmetic circuit 52 outputs a signal indicating the calculated frequency $f_{CLK1}$ to the first signal source 11-1 via the first frequency calculation circuit 14-1, and outputs a signal indicating the calculated frequency $f_{CLK2}$ to the second signal source 11-2 via the second frequency calculation circuit 14-2.

Next, an operation of the reception device illustrated in FIG. 7 will be described.

The antenna 1 receives a frequency-detection target signal propagating in space, and outputs the received signal to the amplifier 2.

The frequency of the signal received by the antenna 1 is $f_{RF}$, and the phase of the signal received by the antenna 1 is $\theta_{RF}$.

The amplifier 2 amplifies the power of the signal received by antenna 1, and outputs the power-amplified signal to each of the first S/H circuit 12-1 of the first frequency detection circuit 3-1 and the second S/H circuit 12-2 of the second frequency detection circuit 3-2.

Since the operation of the first frequency detection circuit 3-1 is substantially the same as the operation of the frequency detection circuit 3 illustrated in FIG. 1, detailed description thereof is omitted here. Note, however, that an operation of the first signal source 11-1 will be described later.

An operation of the second frequency detection circuit 3-2 will be described below.

When the time is $t_0$, the second signal source 11-2 acquires a signal indicating the frequency $f_{CLK2}$ of the third clock signal and a signal indicating the phase $\theta_{CLK3}$ of the third clock signal from the second frequency calculation circuit 14-2.

In a time period of time to $\leq t \leq t_1$, the second signal source 11-2 generates a third clock signal with the frequency $f_{CLK2}$ and the phase $\theta_{CLK3}$ on the basis of the frequency $f_{CLK2}$ of the third clock signal and the phase $\theta_{CLK3}$ of the third clock signal. The second signal source 11-2 outputs the third clock signal to the second S/H circuit 12-2.

When the time is $t_1$, the second signal source 11-2 acquires a signal indicating the frequency $f_{CLK2}$ of the fourth clock signal and a signal indicating the phase $\theta_{CLK4}$ of the fourth clock signal from the second frequency calculation circuit 14-2.

In a time period of time $t_1 < t \leq t_2$, the second signal source 11-2 generates a fourth clock signal with the frequency $f_{CLK2}$ and the phase $\theta_{CLK4}$ on the basis of the frequency $f_{CLK2}$ of the fourth clock signal and the phase $\theta_{CLK4}$ of the fourth clock signal. The second signal source 11-2 outputs the fourth clock signal to the second S/H circuit 12-2.

When receiving the third clock signal from the second signal source 11-2, the second S/H circuit 12-2 undersamples the signal subjected to the power amplification by the amplifier 2 in synchronization with the third clock signal.

The second S/H circuit 12-2 outputs a third sampling signal indicating a result of undersampling to the second filter 13-2.

When receiving the fourth clock signal from the second signal source 11-2, the second S/H circuit 12-2 undersamples the signal subjected to the power amplification by the amplifier 2 in synchronization with the fourth clock signal.

The second S/H circuit 12-2 outputs a fourth sampling signal indicating a result of undersampling to the second filter 13-2.

When receiving the third sampling signal from the second S/H circuit 12-2, the second filter 13-2 passes frequency components within a pass band and suppresses frequency components outside the pass band in the third sampling signal.

When receiving the fourth sampling signal from the second S/H circuit 12-2, the second filter 13-2 passes frequency components within the pass band and suppresses frequency components outside the pass band in the fourth sampling signal.

The second frequency calculation circuit 14-2 calculates a phase difference $\theta_{out4}$-$\theta_{out3}$ or a phase difference $\theta_{out3}$-$\theta_{out4}$ between the third sampling signal output from the second S/H circuit 12-2 and having passed through the second filter 13-2 and the fourth sampling signal output from the second S/H circuit 12-2 and having passed through the second filter 13-2.

The second frequency calculation circuit 14-2 calculates the frequency $f_{RF2}$ of the frequency-detection target signal on the basis of the phase difference $\theta_{out4}$-$\theta_{out3}$ or the phase difference $\theta_{out3}$-$\theta_{out4}$.

The second frequency calculation circuit 14-2 outputs a signal indicating the frequency $f_{RF2}$ to the determination circuit 51.

In the reception device illustrated in FIG. 7, for convenience of description, it is assumed that the frequency calculated by the first frequency calculation circuit 14-1 is $f_{RF1}$.

The determination circuit 51 compares the frequency $f_{RF1}$ calculated by the first frequency calculation circuit 14-1 with the frequency $f_{RF2}$ calculated by the second frequency calculation circuit 14-2.

If the frequency $f_{RF1}$ and the frequency $f_{RF2}$ are the same, the determination circuit 51 determines that both frequencies are the frequency $f_{RF}$ of the frequency-detection target signal.

The determination circuit 51 outputs a signal indicating the frequency $f_{RF1}$ or a signal indicating the frequency $f_{RF2}$ to an external circuit (not illustrated) as the frequency $f_{RF}$ of the frequency-detection target signal.

If the frequency $f_{RF1}$ and the frequency $f_{RF2}$ are different from each other, the determination circuit 51 determines which frequency is closer to the true frequency $f_{RF}$ of the frequency-detection target signal.

Hereinafter, a determination process of the determination circuit 51 in a case where the frequency $f_{RF1}$ and the frequency $f_{RF2}$ are different from each other will be specifically described.

When neither the event (1) nor (2) occurs in first frequency detection circuit 3-1, the degree d (hereinafter, referred to as "degree $d_1$") calculated by the degree calculation circuit 25 of the first frequency calculation circuit 14-1 is an integer or a value close to an integer.

When either the event (1) or (2) occurs in the first frequency detection circuit 3-1, the degree $d_1$ calculated by the degree calculation circuit 25 of the first frequency calculation circuit 14-1 is not an integer but a decimal number in which the degree $d_1$ is far away from the integer.

In addition, when neither the event (1) nor (2) occurs in the second frequency detection circuit 3-2, the degree d (hereinafter, referred to as "degree $d_2$") calculated by the degree calculation circuit 25 of the second frequency calculation circuit 14-2 is an integer or a value close to an integer.

When either the event (1) or (2) occurs in the second frequency detection circuit 3-2, the degree $d_2$ calculated by the degree calculation circuit 25 of the second frequency calculation circuit 14-2 is not an integer but a decimal number in which the degree $d_2$ is far away from the integer.

First, the determination circuit 51 obtains a decimal point value $DP_1$ of the degree $d_1$ calculated by the degree calculation circuit 25 of the first frequency calculation circuit 14-1. When the degree $d_1$ is, for example, 3.61, the decimal point value $DP_1$ is 61, and when the degree $d_1$ is, for example, 3.24, the decimal point value $DP_1$ is 24.

If the value of the first decimal place of the degree $d_1$ is smaller than or equal to four, the determination circuit 51 calculates the absolute value $|\Delta DP_1|$ of the difference between the degree $d_1$ calculated by the degree calculation circuit 25 of the first frequency calculation circuit 14-1 and the value $d_{1,\,1}$ of the first place of the degree $d_1$ as represented by the following expression (16).

$$|\Delta DP_1| = |d_1 - d_{1,\,1}| \qquad (16)$$

If the value of the first decimal place of the degree $d_1$ is larger than or equal to five, the determination circuit 51 calculates the absolute value $|\Delta DP_1|$ of the difference between the value $d_{1,\,1}$+1 of the first place of the degree $d_1$ calculated by the degree calculation circuit 25 of the first frequency calculation circuit 14-1 and the degree $d_1$ as represented by the following expression (17).

$$|\Delta DP_1| = |(d_{1,\,1} + 1) - d_1| \qquad (17)$$

If the degree $d_1$ calculated by the degree calculation circuit 25 of the first frequency calculation circuit 14-1 is, for example, 3.25, the determination circuit 51 calculates the absolute value $|\Delta DP_1| = |3.25 - 3| = 0.25$ by the expression (16).

If the degree $d_1$ calculated by the degree calculation circuit 25 of the first frequency calculation circuit 14-1 is, for example, 3.77, the determination circuit 51 calculates the absolute value $|\Delta DP_1| = |4 - 3.77| = 0.23$ by the expression (17).

Next, the determination circuit 51 obtains a decimal point value $DP_2$ of the degree $d_2$ calculated by the degree calculation circuit 25 of the second frequency calculation circuit 14-2. When the degree $d_2$ is, for example, 3.43, the decimal point value $DP_2$ is 43, and when the degree $d_2$ is, for example, 3.18, the decimal point value $DP_2$ is 18.

If the value of the first decimal place of the degree $d_2$ is smaller than or equal to four, the determination circuit 51 calculates the absolute value $|\Delta DP_2|$ of the difference between the degree $d_2$ calculated by the degree calculation circuit 25 of the second frequency calculation circuit 14-2 and the value $d_{2,\,1}$ of the first place of the degree $d_2$ as represented by the following expression (18).

$$|\Delta DP_2| = |d_2 - d_{2,\,1}| \qquad (18)$$

If the value of the first decimal place of the degree $d_2$ is larger than or equal to five, the determination circuit 51 calculates the absolute value $|\Delta DP_2|$ of the difference between the value $d_{2,\,1}+1$ of the first place of the degree $d_2$ calculated by the degree calculation circuit 25 of the second frequency calculation circuit 14-2 and the degree $d_2$ as represented by the following expression (19).

$$|\Delta DP_2| = |(d_{2,\,1} + 1) - d_2| \qquad (19)$$

If the degree $d_2$ calculated by the degree calculation circuit 25 of the second frequency calculation circuit 14-2 is, for example, 3.47, the determination circuit 51 calculates the absolute value $|\Delta DP_2| = |3.47 - 3| = 0.47$ by the expression (18).

If the degree $d_2$ calculated by the degree calculation circuit 25 of the second frequency calculation circuit 14-2 is, for example, 3.75, the determination circuit 51 calculates the absolute value $|\Delta DP_2| = |4 - 3.75| = 0.25$ by the expression (19).

If the absolute value $|\Delta DP_1|$ of the difference is smaller than the absolute value $|\Delta DP_2|$ of the difference, the degree $d_1$ calculated by the degree calculation circuit 25 of the first frequency calculation circuit 14-1 is closer to an integer than the degree $d_2$ calculated by the degree calculation circuit 25 of the second frequency calculation circuit 14-2. As a result, the frequency $f_{RF1}$ calculated by the first frequency calculation circuit 14-1 is more likely to be the frequency $f_{RF}$ of the frequency-detection target signal than the frequency $f_{RF2}$ calculated by the second frequency calculation circuit 14-2.

On the other hand, if the absolute value $|\Delta DP_1|$ of the difference is larger than the absolute value $|\Delta DP_2|$ of the difference, the degree $d_2$ calculated by the degree calculation circuit 25 of the second frequency calculation circuit 14-2 is closer to an integer than the degree $d_1$ calculated by the degree calculation circuit 25 of the first frequency calculation circuit 14-1. As a result, the frequency $f_{RF2}$ calculated by the second frequency calculation circuit 14-2 is more likely to be the frequency $f_{RF}$ of the frequency-detection target signal than the frequency $f_{RF1}$ calculated by the first frequency calculation circuit 14-1.

The determination circuit 51 compares the absolute value $|\Delta DP_1|$ of the difference with the absolute value $|\Delta DP_2|$ of the difference.

When the absolute value $|\Delta DP_1|$ of the difference is smaller than or equal to the absolute value $|\Delta DP_2|$ of the difference, the determination circuit 51 determines that the frequency $f_{RF1}$ calculated by the first frequency calculation circuit 14-1 is a frequency close to the true frequency $f_{RF}$ of the frequency-detection target signal.

When the absolute value $|\Delta DP_1|$ of the difference is larger than the absolute value $|\Delta DP_2|$ of the difference, the determination circuit 51 determines that the frequency $f_{RF2}$ calculated by the second frequency calculation circuit 14-2 is a frequency close to the true frequency $f_{RF}$ of the frequency-detection target signal.

When determining that the frequency $f_{RF1}$ calculated by the first frequency calculation circuit 14-1 is a frequency close to the true frequency $f_{RF}$ of the frequency-detection target signal, the determination circuit 51 outputs a signal indicating the frequency $f_{RF1}$ to an external circuit (not illustrated).

When determining that the frequency $f_{RF2}$ calculated by the second frequency calculation circuit 14-2 is a frequency close to the true frequency $f_{RF}$ of the frequency-detection target signal, the determination circuit 51 outputs a signal indicating the frequency $f_{RF2}$ to an external circuit (not illustrated).

In the reception device illustrated in FIG. 7, the determination circuit 51 determines which frequency is close to the true frequency of the frequency-detection target signal on the basis of the degree $d_1$ calculated by the degree calculation circuit 25 of the first frequency calculation circuit 14-1 and the degree $d_2$ calculated by the degree calculation circuit 25 of the second frequency calculation circuit 14-2. However, this is merely an example, and the determination circuit 51 can determine which frequency is close to the true frequency of the frequency-detection target signal on the basis of the frequency $f_{RF1}$ calculated by the first frequency calculation circuit 14-1 and the frequency $f_{RF2}$ calculated by the second frequency calculation circuit 14-2.

Specifically, it is as follows.

When neither the event (1) nor (2) occurs in the first frequency detection circuit 3-1, the frequency $f_{RF1}$ calculated by the first frequency calculation circuit 14-1 falls within a frequency range that can be detected by the first frequency detection circuit 3-1.

When either the event (1) or (2) occurs in the first frequency detection circuit 3-1, the frequency $f_{RF1}$ calculated by the first frequency calculation circuit 14-1 is likely to deviate from the frequency range that can be detected by the first frequency detection circuit 3-1.

Furthermore, when neither the event (1) nor (2) occurs in the second frequency detection circuit 3-2, the frequency $f_{RF2}$ calculated by the second frequency calculation circuit 14-2 falls within a frequency range that can be detected by the second frequency detection circuit 3-2.

When either the event (1) or (2) occurs in the second frequency detection circuit 3-2, the frequency $f_{RF2}$ calculated by the second frequency calculation circuit 14-2 is likely to deviate from the frequency range that can be detected by the second frequency detection circuit 3-2.

Case (1)

The frequency $f_{RF1}$ calculated by the first frequency calculation circuit 14-1 falls within a frequency range that can be detected by the first frequency detection circuit 3-1. In addition, the frequency $f_{RF2}$ calculated by the second frequency calculation circuit 14-2 deviates from a frequency range that can be detected by the second frequency detection circuit 3-2.

In the case (1), the determination circuit 51 determines that the frequency $f_{RF1}$ calculated by the first frequency calculation circuit 14-1 is a frequency close to the true frequency $f_{RF}$ of the frequency-detection target signal.

Case (2)

The frequency $f_{RF1}$ calculated by the first frequency calculation circuit 14-1 deviates from the frequency range that can be detected by the first frequency detection circuit 3-1. In addition, the frequency $f_{RF2}$ calculated by the second frequency calculation circuit 14-2 falls within the frequency range that can be detected by the second frequency detection circuit 3-2.

In the case (2), the determination circuit 51 determines that the frequency $f_{RF2}$ calculated by the second frequency calculation circuit 14-2 is a frequency close to the true frequency $f_{RF}$ of the frequency-detection target signal.

Case (3)

The frequency $f_{RF1}$ calculated by the first frequency calculation circuit 14-1 falls within the frequency range that can be detected by the first frequency detection circuit 3-1. In addition, the frequency $f_{RF2}$ calculated by the second frequency calculation circuit 14-2 also falls within the frequency range that can be detected by the second frequency detection circuit 3-2.

In the case (3), there is a high possibility that neither the event (1) nor (2) occurs in each of the first frequency detection circuit 3-1 and the second frequency detection circuit 3-2. Consequently, the determination circuit 51 determines that one or the other of the frequency $f_{RF1}$ calculated by the first frequency calculation circuit 14-1 and the frequency $f_{RF2}$ calculated by the second frequency calculation circuit 14-2 is a frequency close to the true frequency $f_{RF}$ of the frequency-detection target signal.

Case (4)

The frequency $f_{RF1}$ calculated by the first frequency calculation circuit 14-1 deviates from the frequency range that can be detected by the first frequency detection circuit 3-1. In addition, the frequency $f_{RF2}$ calculated by the second frequency calculation circuit 14-2 also deviates from the frequency range that can be detected by the second frequency detection circuit 3-2.

In the case (4), there is a high possibility that either the event (1) or (2) occurs in each of the first frequency detection circuit 3-1 and the second frequency detection circuit 3-2. As a result, the determination circuit 51 determines that both the frequency $f_{RF1}$ calculated by the first frequency calculation circuit 14-1 and the frequency $f_{RF2}$ calculated by the second frequency calculation circuit 14-2 are not the frequency $f_{RF}$ of the frequency-detection target signal.

The arithmetic circuit 52 calculates the frequencies $f_{CLK1}$ and $f_{CLK2}$ capable of preventing each of the events (1) and (2).

The arithmetic circuit 52 outputs a signal indicating the calculated frequency $f_{CLK1}$ to the first signal source 11-1 via the first frequency calculation circuit 14-1, and outputs a signal indicating the calculated frequency $f_{CLK2}$ to the second signal source 11-2 via the second frequency calculation circuit 14-2.

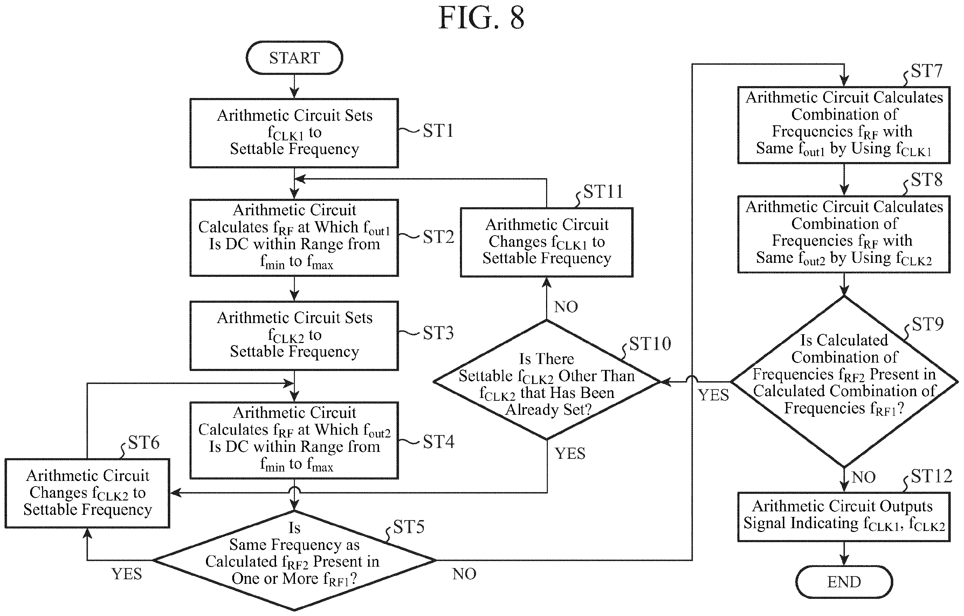

FIG. 8 is a flowchart illustrating an operation of the arithmetic circuit 52 of the reception device according to the second embodiment.

Hereinafter, the operation of the arithmetic circuit 52 will be specifically described with reference to FIG. 8.

In the reception device illustrated in FIG. 7, it is assumed that the minimum value of a detectable frequency range in each of the first frequency detection circuit 3-1 and the second frequency detection circuit 3-2 is $f_{min}$, and the maximum value of each detectable frequency range is $f_{max}$.

First, the arithmetic circuit 52 sets the frequency $f_{CLK1}$ of each of a first clock signal and a second clock signal to a settable frequency (step ST1 in FIG. 8).

In a case where the frequency range of a signal that can be output from the first signal source 11-1 is, for example, 1 to 2 GHz, and the resolution of the frequency range of the signal that can be output is, for example, 0.5 GHz, the settable frequency $f_{CLK1}$ is 1 GHz, 1.5 GHz, and 2 GHz. Consequently, the arithmetic circuit 52 sets any one of the frequencies 1 GHz, 1.5 GHz, and 2 GHz as the frequency $f_{CLK1}$.

Next, the arithmetic circuit 52 calculates the frequency $f_{RF1}$ at which the frequency $f_{out1}$ included in the output signal of the first filter 13-1 is DC within the range from the minimum value $f_{min}$ to the maximum value $f_{max}$ on the basis of the set frequency $f_{CLK1}$ (step ST2 in FIG. 8). There is one or a plurality of frequencies $f_{RF1}$ at which the frequency $f_{out1}$ is DC.

Since the process itself of calculating the frequency $f_{RF1}$ at which the frequency $f_{out1}$ is DC is a known technique, detailed description thereof is omitted.

Next, the arithmetic circuit 52 sets the frequency $f_{CLK2}$ of each of a third clock signal and a fourth clock signal to a settable frequency (step ST3 in FIG. 8).

In a case where the frequency range of a signal that can be output from the second signal source 11-2 is, for example, 3 to 4 GHz, and the resolution of the frequency range of the signal that can be output is, for example, 0.5 GHz, the settable frequency $f_{CLK2}$ is 3 GHz, 3.5 GHz, and 4 GHz. Consequently, the arithmetic circuit 52 sets any one of the frequencies 3 GHz, 3.5 GHz, and 4 GHz as the frequency $f_{CLK2}$.

Next, the arithmetic circuit 52 calculates the frequency $f_{RF2}$ at which the frequency $f_{out2}$ included in the output signal of the second filter 13-2 is DC within the range from the minimum value $f_{min}$ to the maximum value $f_{max}$ on the basis of the set frequency $f_{CLK2}$ (step ST4 in FIG. 8). There is one or a plurality of frequencies $f_{RF2}$ at which the frequency $f_{out2}$ is DC.

Since the process itself of calculating the frequency $f_{RF2}$ at which the frequency $f_{out2}$ is DC is a known technique, detailed description thereof is omitted.

The arithmetic circuit 52 compares one or more frequencies $f_{RF1}$ at which the frequency $f_{out1}$ is DC with one or more frequencies $f_{RF2}$ at which the frequency $f_{out2}$ is DC.

If the same frequency as the calculated frequency $f_{RF2}$ is present in the calculated one or more frequencies $f_{RF1}$ (step ST5 in FIG. 8: YES), the arithmetic circuit 52 changes the set frequency $f_{CLK2}$ of each of the third clock signal and the fourth clock signal to the settable frequency (step ST6 in FIG. 8). The changed frequency is a frequency that has not yet been set among a plurality of settable frequencies.

After changing the set frequency $f_{CLK2}$, the arithmetic circuit 52 calculates the frequency $f_{RF2}$ at which the frequency $f_{out2}$ included in the output signal of the second filter 13-2 is DC within the range from the minimum value $f_{min}$ to the maximum value $f_{max}$ on the basis of the changed frequency $f_{CLK2}$ (step ST4 in FIG. 8).

If the same frequency as the calculated frequency $f_{RF2}$ is not present in the calculated one or more frequencies $f_{RF1}$ (step ST5 in FIG. 8: NO), the arithmetic circuit 52 calculates a combination of the frequencies $f_{RF1}$ with the same frequency $f_{out1}$ by using the frequency $f_{CLK1}$ of each of the first clock signal and the second clock signal (step ST7 in FIG. 8).

For example, in a case where $f_{CLK1}$ = 1 GHz, $f_{out1}$ corresponding to $f_{RF1}$ = 1.1 GHz and $f_{out1}$ corresponding to $f_{RF1}$ = 1.9 GHz are the same frequency = 0.1 GHz.

The arithmetic circuit 52 calculates a combination of the frequencies $f_{RF2}$ with the same frequency $f_{out2}$ by using the frequency $f_{CLK2}$ of each of the third clock signal and the fourth clock signal (step ST8 in FIG. 8).

For example, in a case where $f_{CLK2}$ = 1.5 GHz, $f_{out2}$ corresponding to $f_{RF2}$ = 1.6 GHz and $f_{out2}$ corresponding to $f_{RF2}$ = 2.9 GHz are the same frequency = 0.1 GHz.

Next, the arithmetic circuit 52 compares the calculated combination of the frequencies $f_{RF1}$ with the calculated combination of the frequencies $f_{RF2}$.

In a case where the calculated combination of the frequencies $f_{RF2}$ is present in the calculated combination of the frequencies $f_{RF1}$ (step ST9 in FIG. 8: YES), the arithmetic circuit 52 determines whether or not there is a settable frequency $f_{CLK2}$ other than the frequency $f_{CLK2}$ that has already been set.

If there is a settable frequency $f_{CLK2}$ other than the frequency $f_{CLK2}$ that has already been set (step ST10 of FIG. 8: YES), the arithmetic circuit 52 changes the frequency $f_{CLK2}$ to the settable frequency (step ST6 of FIG. 8).

If there is no settable frequency $f_{CLK2}$ other than the frequency $f_{RF2}$ that has already been set (step ST10 in FIG. 8: NO), the arithmetic circuit 52 changes the set frequency $f_{CLK1}$ of each of the first clock signal and the second clock signal to the settable frequency (step ST11 in FIG. 8). The changed frequency is a frequency that has not yet been set among a plurality of settable frequencies.

In a case where there is no calculated combination of the frequencies $f_{RF2}$ in the calculated combination of the frequencies $f_{RF1}$ (step ST9 in FIG. 8: NO), the arithmetic circuit 52 outputs a signal indicating the frequency $f_{CLK1}$ set lately to the first signal source 11-1 via the first frequency calculation circuit 14-1 (step ST12 in FIG. 8).

Furthermore, the arithmetic circuit 52 outputs a signal indicating the frequency $f_{CLK2}$ set lately to the second signal source 11-2 via the second frequency calculation circuit 14-2 (step ST12 in FIG. 8).

When receiving the signal indicating the frequency $f_{CLK1}$ from the arithmetic circuit 52 via the first frequency calculation circuit 14-1, the first signal source 11-1 generates the first clock signal with the frequency $f_{CLK1}$ and the phase $\theta_{CLK1}$ on the basis of the phase $\theta_{CLK1}$ of the first clock signal indicated by the signal output from the first frequency calculation circuit 14-1.

The first signal source 11-1 outputs the generated first clock signal to the first S/H circuit 12-1.

In addition, the first signal source 11-1 generates the second clock signal with the frequency $f_{CLK1}$ and the phase $\theta_{CLK2}$ on the basis of the phase $\theta_{CLK2}$ of the second clock signal indicated by the signal output from the first frequency calculation circuit 14-1.

The first signal source 11-1 outputs the generated second clock signal to the first S/H circuit 12-1.

The first signal source 11-1 outputs each of the first clock signal and the second clock signal to the first S/H circuit 12-1, so that the occurrence of the event (1) or (2) in the first frequency detection circuit 3-1 is prevented.

When receiving the signal indicating the frequency $f_{CLK2}$ from the arithmetic circuit 52 via the second frequency calculation circuit 14-2, the second signal source 11-2 generates the third clock signal with the frequency $f_{CLK2}$ and the phase $\theta_{CLK3}$ on the basis of the phase $\theta_{CLK3}$ of the third clock signal indicated by the signal output from the second frequency calculation circuit 14-2.

The second signal source 11-2 outputs the generated third clock signal to the second S/H circuit 12-2.

In addition, the second signal source 11-2 generates the fourth clock signal with the frequency of $f_{CLK2}$ and the phase $\theta_{CLK4}$ on the basis of the phase $\theta_{CLK4}$ of the fourth clock signal indicated by the signal output from the second frequency calculation circuit 14-2.

The second signal source 11-2 outputs the generated fourth clock signal to the second S/H circuit 12-2.

The second signal source 11-2 outputs each of the third clock signal and the fourth clock signal to the second S/H circuit 12-2, so that the occurrence of the event (1) or (2) in the second frequency detection circuit 3-2 is prevented.

Note that, in the present invention, it is possible to freely combine the embodiments, modify any component of each embodiment, or omit any component in each embodiment within the scope of the invention.

INDUSTRIAL APPLICABILITY

The present invention is suitable for a frequency detection circuit and a reception device that calculate a frequency of a frequency-detection target signal.

REFERENCE SIGNS LIST

1: antenna, 1a: output terminal, 2: amplifier, 2a: input terminal, 2b: output terminal, 3: frequency detection circuit, 3-1: first frequency detection circuit, 3-2: second frequency detection circuit, 11: signal source, 11-1: first signal source, 11-2: second signal source, 11a, 11-la, 11-2a: control terminal, 11b, 11-lb, 11-2b: output terminal, 12: S/H circuit, 12-1: first S/H circuit, 12-2: second S/H circuit, 12a, 12-1a, 12-1b: input terminal, 12b, 12-1b, 12-2b: clock terminal, 12c, 12-1c, 12-2c: output terminal, 13: filter, 13-1: first filter, 13-2: second filter, 13a, 13-1a, 13-2a: input terminal, 13b, 13-1b, 13-2b: output terminal, 14: frequency calculation circuit, 14-1: first frequency calculation circuit, 14-2: second frequency calculation circuit, 14a, 14-1a, 14-2a: input terminal, 14b, 14-1b, 14-2b: first output terminal, 14c, 14-1c, 14-2c: second output terminal, 14-1d, 14-2d: input terminal, 21: quantizer, 21a: input terminal, 21b: output terminal, 22: first frequency calculation circuit, 22a: input terminal, 22b: output terminal, 23: phase calculation circuit, 23a: input terminal, 23b: output terminal, 24: phase-difference calculation circuit, 24a: first input terminal, 24b: second input terminal, 24c: output terminal, 25: degree calculation circuit, 25a: input terminal, 25b: output terminal, 26: second frequency calculation circuit, 26a: first input terminal, 26b: second input terminal, 26c: output terminal, 27: phase control circuit, 27a: first output terminal, 27b: second output terminal, 31: delay circuit, 32: mixer, 33: quantizer, 34: memory, 35: arithmetic unit, 41: delay circuit, 42: mixer, 43: memory, 44: arithmetic unit, 50: frequency detection circuit, 51: determination circuit, 51a: first input terminal, 51b: second input terminal, 51c: output terminal, 52: arithmetic circuit, 52a: first output terminal, 52b: second output terminal

**Claims**

1.  A frequency detection circuit comprising:

    a signal source to output a first clock signal and a second clock signal that has a same frequency as the first clock signal and a different phase from the first clock signal;
    a sample and hold circuit to undersample a frequency-detection target signal using the first clock signal output from the signal source and output a first sampling signal indicating a result of undersampling, and undersample the frequency-detection target signal using the second clock signal output from the signal source and output a second sampling signal indicating a result of undersampling; and
    a frequency calculation circuit to calculate a phase difference between the first sampling signal output from the sample and hold circuit and the second sampling signal output from the sample and hold circuit and calculate a frequency of the frequency-detection target signal on a basis of the phase difference.

2.  The frequency detection circuit according to claim 1, wherein

    the frequency calculation circuit
    calculates a degree of undersampling in the sample and hold circuit on a basis of the phase difference,
    detects a frequency of the first sampling signal or a frequency of the second sampling signal, and
    calculates a frequency of the frequency-detection target signal using the frequency of the first sampling signal or the frequency of the second sampling signal, a frequency of the first clock signal or a frequency of the second clock signal, and the degree of the undersampling.

3.  The frequency detection circuit according to claim 2, wherein the frequency calculation circuit calculates a degree of the undersampling from a phase difference between the first clock signal and the second clock signal and a phase difference between the first sampling signal and the second sampling signal.

4.  The frequency detection circuit according to claim 3, wherein

    when a product of a frequency of the first clock signal or a frequency of the second clock signal and a degree of the undersampling is smaller than or equal to a frequency of the frequency-detection target signal,
    the frequency calculation circuit calculates n that is the degree of the undersampling by substituting $\theta_{CLK2}-\theta_{CLK1}$ that is a phase difference between the first clock signal and the second clock signal and $\theta_{out2}-\theta_{out1}$ that is a phase difference between the first sampling signal and the second sampling signal into an expression (1) below,

    $$n = -\frac{\theta_{out2} - \theta_{out1}}{\theta_{CLK2} - \theta_{CLK1}} \qquad (1)$$

    and
    when the product is larger than the frequency of the frequency-detection target signal,
    the frequency calculation circuit calculates n that is the degree of the undersampling by substituting the $\theta_{CLK2}-\theta_{CLK1}$ and the $\theta_{out2}-\theta_{out1}$ into an expression (2) below.

    $$n = \frac{\theta_{out2} - \theta_{out1}}{\theta_{CLK2} - \theta_{CLK1}} \qquad (2)$$

5.  The frequency detection circuit according to claim 4, wherein

    when the product is smaller than or equal to a frequency of the frequency-detection target signal,
    the frequency calculation circuit calculates $f_{RF}$ that is a frequency of the frequency-detection target signal by substituting $f_{out}$ that is a frequency of the first sampling signal or $f_{out}$ that is a frequency of the second sampling signal, $f_{CLK}$ that is a frequency of the first clock signal or $f_{CLK}$ that is a frequency of the second clock signal, and n that is a degree calculated by the expression (1) into an expression (3) below,

$$f_{RF} = f_{out} + n \cdot f_{CLK} \qquad (3)$$

and
when the product is larger than the frequency of the frequency-detection target signal,
the frequency calculation circuit calculates $f_{RF}$ that is the frequency of the frequency-detection target signal by substituting $f_{out}$ that is the frequency of the first sampling signal or $f_{out}$ that is the frequency of the second sampling signal, $f_{CLK}$ that is the frequency of the first clock signal or $f_{CLK}$ that is the frequency of the second clock signal, and n that is a degree calculated by the expression (2) into an expression (4) below.

$$f_{RF} = -f_{out} + n \cdot f_{CLK} \qquad (4)$$

6. The frequency detection circuit according to claim 1, wherein

the signal source is a first signal source, the sample and hold circuit is a first sample and hold circuit, and the frequency calculation circuit is a first frequency calculation circuit, and the frequency detection circuit further comprising:

a second signal source to output a third clock signal that has a different frequency from the first clock signal and a fourth clock signal that has a same frequency as the third clock signal and a different phase from the third clock signal;
a second sample and hold circuit to undersample the frequency-detection target signal using the third clock signal output from the second signal source and output a third sampling signal indicating a result of undersampling, and undersample the frequency-detection target signal using the fourth clock signal output from the second signal source and output a fourth sampling signal indicating a result of undersampling;
a second frequency calculation circuit to calculate a phase difference between the third sampling signal output from the second sample and hold circuit and the fourth sampling signal output from the second sample and hold circuit and calculate a frequency of the frequency-detection target signal on a basis of the phase difference between the third sampling signal and the fourth sampling signal; and
a determination circuit to determine which of a frequency calculated by the first frequency calculation circuit and a frequency calculated by the second frequency calculation circuit is a frequency closer to a true frequency of the frequency-detection target signal.

7. The frequency detection circuit according to claim 6, wherein

the first frequency calculation circuit calculates a degree of undersampling in the first sample and hold circuit on a basis of a phase difference between the first sampling signal and the second sampling signal,
the second frequency calculation circuit calculates a degree of undersampling in the second sample and hold circuit on a basis of a phase difference between the third sampling signal and the fourth sampling signal, and
the determination circuit determines which of a frequency calculated by the first frequency calculation circuit and a frequency calculated by the second frequency calculation circuit is a frequency closer to a true frequency of the frequency-detection target signal on a basis of the degree calculated by the first frequency calculation circuit and the degree calculated by the second frequency calculation circuit.

8. A reception device comprising the frequency detection circuit according to any one of claims 1 to 7 as a frequency detection circuit that calculates a frequency of a signal received by an antenna, the signal being the frequency-detection target signal.

# FIG. 1

# FIG. 2

# FIG. 3

↑:Frequency Component Included in Input Signal of S/H Circuit 12

⇣:Frequency Component Included in Output Signal of S/H Circuit 12

Pass Band of Filter 13

Frequency Component Included in Output Signal of Filter 13

Power

$f_{out}$  $f_{CLK}/2$  $f_{CLK}$  $3f_{CLK}/2$  $2f_{CLK}$  ...  $(n-2)f_{CLK}/2$  $(n-1)f_{CLK}/2$  $n \cdot f_{CLK}/2$  $f_{RF}$

Frequency

# FIG. 4

# FIG. 5

Frequency Calculation Circuit — 14

$f_{out}, \theta_{out1}$
or
$f_{out}, \theta_{out2}$

21 — Quantizer

22 — First Frequency Calculation Circuit

26 — Second Frequency Calculation Circuit

24 — Phase-Difference Calculation Circuit

34 — Memory

31 — Delay Circuit

32 — Mixer

33 — Quantizer

35 — Arithmetic Unit

25 — Degree Calculation Circuit

$t_1$

27 — Phase Control Circuit

$\theta_{CLK1}, \theta_{CLK2}$

EP 4 033 257 A1

28

# FIG. 6

EP 4 033 257 A1

EP 4 033 257 A1

FIG. 7

Frequency Detection Circuit

50

First Frequency Detection Circuit 3-1

Amplifier 2

$f_{RF}$ $\theta_{RF}$

First S/H Circuit 12-1 (12-1a)

$f_{CLK1}, \theta_{CLK1}$ or $f_{CLK1}, \theta_{CLK2}$

First Filter 13-1 (13-1a)

$f_{out1}, \theta_{out1}$ or $f_{out1}, \theta_{out2}$

First Frequency Calculation Circuit 14-1

First Signal Source 11-1

$f_{CLK1}, \theta_{CLK1}, \theta_{CLK2}$

Determination Circuit 51

Arithmetic Circuit 52

Second Frequency Detection Circuit 3-2

Second S/H Circuit 12-2 (12-2a)

$f_{CLK2}, \theta_{CLK3}$ or $f_{CLK2}, \theta_{CLK4}$

Second Filter 13-2 (13-2a)

$f_{out2}, \theta_{out3}$ or $f_{out2}, \theta_{out4}$

Second Frequency Calculation Circuit 14-2

Second Signal Source 11-2

$f_{CLK2}, \theta_{CLK3}, \theta_{CLK4}$

# FIG. 8

START

Arithmetic Circuit Sets $f_{CLK1}$ to Settable Frequency — ST1

Arithmetic Circuit Calculates $f_{RF}$ at Which $f_{out1}$ Is DC within Range from $f_{min}$ to $f_{max}$ — ST2

Arithmetic Circuit Sets $f_{CLK2}$ to Settable Frequency — ST3

Arithmetic Circuit Calculates $f_{RF}$ at Which $f_{out2}$ Is DC within Range from $f_{min}$ to $f_{max}$ — ST4

Is Same Frequency as Calculated $f_{RF2}$ Present in One or More $f_{RF1}$? — ST5

YES → Arithmetic Circuit Changes $f_{CLK2}$ to Settable Frequency — ST6

NO →

Is There Settable $f_{CLK2}$ Other Than $f_{CLK2}$ that Has Been Already Set? — ST10

NO → Arithmetic Circuit Changes $f_{CLK1}$ to Settable Frequency — ST11

YES →

Is Calculated Combination of Frequencies $f_{RF2}$ Present in Calculated Combination of Frequencies $f_{RF1}$? — ST9

YES → (to ST10)

Arithmetic Circuit Calculates Combination of Frequencies $f_{RF}$ with Same $f_{out1}$ by Using $f_{CLK1}$ — ST7

Arithmetic Circuit Calculates Combination of Frequencies $f_{RF}$ with Same $f_{out2}$ by Using $f_{CLK2}$ — ST8

NO → Arithmetic Circuit Outputs Signal Indicating $f_{CLK1}$, $f_{CLK2}$ — ST12

END

EP 4 033 257 A1

<div align="center">

**INTERNATIONAL SEARCH REPORT**

</div>

| International application No. |
| --- |
| PCT/JP2019/046159 |

**A. CLASSIFICATION OF SUBJECT MATTER**
Int. Cl. G01R23/12(2006.01)i
FI: G01R23/12

According to International Patent Classification (IPC) or to both national classification and IPC

**B. FIELDS SEARCHED**

Minimum documentation searched (classification system followed by classification symbols)
Int. Cl. G01R23/12

Documentation searched other than minimum documentation to the extent that such documents are included in the fields searched
Published examined utility model applications of Japan       1922-1996
Published unexamined utility model applications of Japan     1971-2020
Registered utility model specifications of Japan             1996-2020
Published registered utility model applications of Japan     1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | 和田平, 2つのS/H回路のクロック信号と出力信号の位相差情報を用い | 1-5, 8 |
| A | たアンダーサンプリング周波数検出方式, 電子情報通信学会技術研究報 | 6-7 |
|  | 告, vol. 119, no. 292, Institute of Electronics, Information and Communication Engineers, 07 November 2019, pp. 7-12, in particular, "2. Proposed Method" (WADA, Osamu et al. An Undersampling Frequency Detection Method Using Phase Difference of Clock Signals and Output Signals of Two S/H circuits. IEICE Technical Report.) | |
| A | JP 2017-216604 A (NATIONAL INSTITUTE OF INFORMATION AND COMMUNICATIONS TECHNOLOGY) 07 December 2017, entire text, all drawings | 1-8 |

| ☒ | Further documents are listed in the continuation of Box C. | ☒ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 27.01.2020 | 04.02.2020 |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**EP 4 033 257 A1**

<table>
<tr><td colspan="2" align="center">**INTERNATIONAL SEARCH REPORT**</td><td>International application No.<br>PCT/JP2019/046159</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-162662 A (NEC CORP.) 23 July 2009, entire text, all drawings | 1-8 |
| A | JP 2009-300436 A (ADVANTEST CORP.) 24 December 2009, entire text, all drawings | 1-8 |

33

INTERNATIONAL SEARCH REPORT
Information on patent family members

International application No.

PCT/JP2019/046159

| Patent Documents referred to in the Report | Publication Date | Patent Family | Publication Date |
|---|---|---|---|
| JP 2017-216604 A | 07.12.2017 | WO 2017/208780 A1 entire text, all drawings | |
| JP 2009-162662 A | 23.07.2009 | (Family: none) | |
| JP 2009-300436 A | 24.12.2009 | US 2009/0306917 A1 entire text, all drawings | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017216604 A